# EUROPÄISCHE PATENTSCHRIFT

(11) **EP 2 984 093 B1**
(45) Veröffentlichungstag und Bekanntmachung des Hinweises auf die Patenterteilung: **26.09.2018**
(21) Anmeldenummer: 14710815.3
(22) Anmeldetag: 14.03.2014
(51) Int. Cl.: C07F 15/00, H01L 51/00, C09K 11/00, C08G 61/00, H05B 33/00

(54) **METALLKOMPLEXE UND IHRE VERWENDUNG IN ELEKTRONISCHEN VORRICHTUNGEN**
METAL COMPLEXES AND USE THEREOF IN ELECTRONIC DEVICES
COMPLEXES MÉTALLIQUES ET LEUR UTILISATION DANS DES DISPOSITIFS ÉLECTRONIQUES

(30) Priorität: 11.04.2013 EP 13001885
(43) Veröffentlichungstag der Anmeldung: 17.02.2016
(73) Patentinhaber: Merck Patent GmbH, 64293 Darmstadt (DE)
(72) Erfinder: STOESSEL, Philipp, 60487 Frankfurt am Main (DE); KOENEN, Nils, 64285 Darmstadt (DE); BREUNING, Esther, 64372 Ober-Ramstadt (DE)
(86) Internationale Anmeldenummer: PCT/EP2014/000707
(87) Internationale Veröffentlichungsnummer: WO 2014/166577

(56) Entgegenhaltungen:
- DE-A1-102009 049 587

## Beschreibung

Die vorliegende Erfindung betrifft Metallkomplexe zur Verwendung in elektronischen Vorrichtungen, insbesondere als Emitter in organischen Elektrolumineszenzvorrichtungen, sowie organische Elektrolumineszenzvorrichtungen enthaltend diese Metallkomplexe.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch Verbesserungsbedarf, insbesondere im Hinblick auf Effizienz, Betriebsspannung und Lebensdauer.

Gemäß dem Stand der Technik werden in phosphoreszierenden OLEDs als Triplettemitter insbesondere Iridium- und Platinkomplexe eingesetzt. Eine Verbesserung dieser OLEDs konnte dadurch erzielt werden, dass Metallkomplexe mit polypodalem Liganden bzw. Kryptate eingesetzt wurden, wodurch die Komplexe eine höhere thermische Stabilität aufweisen, was zu einer höheren Lebensdauer der OLEDs führt (WO 04/081017, WO 05/113563, WO 06/008069). Auch hier sind jedoch noch weitere Verbesserungen wünschenswert.

Aus dem Stand der Technik sind weiterhin Iridiumkomplexe bekannt, welche als Liganden Chinalozin-Derivate enthalten (WO 2011/044988 und DE 10 2009 049 587).

Auch hier sind noch weitere Verbesserungen hinsichtlich Effizienz, Betriebsspannung und Lebensdauer wünschenswert.

Aufgabe der vorliegenden Erfindung ist daher die Bereitstellung neuer Metallkomplexe, welche sich als Emitter für die Verwendung in OLEDs eignen.

Überraschend wurde gefunden, dass bestimmte, unten näher beschriebene Metallchelatkomplexe diese Aufgabe lösen und gute Eigenschaften in organischen Elektrolumineszenzvorrichtung zeigen, insbesondere hinsichtlich der Betriebsspannung, der Effizienz und der Emissionsfarbe. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

M(L)ₙ(L')ₘ Formel (1)

wobei die Verbindung der allgemeinen Formel (1) eine Teilstruktur M(L)ₙ der Formel (2) enthält: 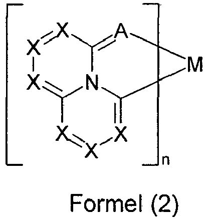 wobei für die verwendeten Symbole und Indizes gilt:
- M: ist ein Übergangsmetall;
- A: ist bei jedem Auftreten gleich oder verschieden O, S oder NR;
- X: ist bei jedem Auftreten gleich oder verschieden CR oder N;
oder zwei benachbarte Gruppen stehen für eine Gruppe der folgenden Formel (3) oder (4), 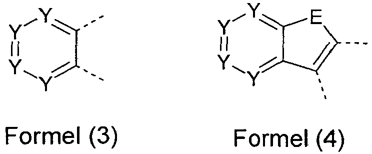 wobei die gestrichelten Bindungen die Verknüpfung dieser Gruppe im Molekül andeuten;
- Y: ist bei jedem Auftreten gleich oder verschieden CR oder N;
- E: ist bei jedem Auftreten gleich oder verschieden CR₂, NR, O oder S;
- R: ist bei jedem Auftreten gleich oder verschieden H, D, F, Cl, Br, I, N(R¹)₂, P(R¹)₂, CN, NO₂, Si(R¹)₃, B(OR¹)₂, C(=O)R¹, P(=O)(R¹)₂, S(=O)R¹, S(=O)₂R¹, OSO₂R¹, OH, SH, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, Ge(R¹)₂, Sn(R¹)₂, C=O, C=S, C=Se, C=NR¹, P(=O)(R¹), SO, SO₂, NR¹, O, S oder CONR¹ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches oder aromatisches Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R² auch miteinander ein mono- oder polycyclisches, aliphatisches oder aromatisches Ringsystem bilden;
- L': ist gleich oder verschieden bei jedem Auftreten ein beliebiger Coligand;
- n: ist 1, 2 oder 3;
- m: ist 0, 1, 2, 3 oder 4;
dabei können auch mehrere Liganden L miteinander oder L mit L' über eine beliebige Brücke V verknüpft sein und so ein tridentates, tetradentates, pentadentates oder hexadentates Ligandensystem aufspannen.

In Formel (3) und (4) sind lokalisierte Doppelbindungen eingezeichnet. Es ist selbstverständlich, dass diese Doppelbindungen nicht notwendigerweise an den Positionen lokalisiert sein müssen, an denen sie eingezeichnet sind. So kann es sich auch um mesomere Grenzstrukturen handeln, oder die Doppelbindungen können an anderen Positionen lokalisiert sein, je nachdem an welcher Position die Gruppe der Formel (3) bzw. (4) an den Liganden gebunden ist.

Dabei werden die Indizes n und m so gewählt, dass die Koordinationszahl am Metall M insgesamt, je nach Metall, der für dieses Metall üblichen Koordinationszahl entspricht. Dies ist für Übergangsmetalle je nach Metall üblicherweise die Koordinationszahl 4, 5 oder 6. Es ist generell bekannt, dass Metallkoordinationsverbindungen abhängig vom Metall und von der Oxidationsstufe des Metalls unterschiedliche Koordinationszahlen aufweisen, also eine unterschiedliche Anzahl von Liganden binden. Da die bevorzugten Koordinationszahlen von Metallen bzw. Metallionen in verschiedenen Oxidationsstufen zum allgemeinen Fachwissen des Fachmanns auf dem Gebiet der metallorganischen Chemie bzw. der Koordinationschemie gehören, ist es für den Fachmann ein Leichtes, je nach Metall und dessen Oxidationsstufe und je nach genauer Struktur des Liganden L eine geeignete Anzahl Liganden zu verwenden und somit die Indizes n und m geeignet zu wählen.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Die Liganden können auch über ein Carben-Kohlenstoffatom an das Metall binden. Ein cyclisches Carben im Sinne dieser Erfindung ist eine cyclische Gruppe, welche über ein neutrales C-Atom an das Metall bindet. Dabei kann die cyclische Gruppe gesättigt oder ungesättigt sein. Bevorzugt sind hierbei Arduengo-Carbene, also solche Carbene, bei welchen an das Carben-C-Atom zwei Stickstoffatome gebunden sind. Dabei wird ein Fünfring-Arduengo-Carben bzw. ein anderes ungesättigtes Fünfring-Carben ebenfalls als eine Arylgruppe im Sinne dieser Erfindung angesehen.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N- oder O-Atom oder eine Carbonylgruppe, verbunden sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylengruppe oder durch eine Silylengruppe verbunden sind.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, Cyclohexyl, 2-Methylpentyl, neo-Hexyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladungen der Liganden L und L' so gewählt werden, dass sie die Ladung des komplexierten Metallatoms M kompensieren.

Bevorzugt sind weiterhin Verbindungen gemäß Formel (1), dadurch gekennzeichnet, dass die Summe der Valenzelektronen um das Metallatom in drei- und vierfach koordinierten Komplexen 16 und in fünffach koordinierten Komplexen 16 oder 18 und in sechsfach koordinierten Komplexen 18 beträgt. Diese Bevorzugung ist durch die besondere Stabilität dieser Metallkomplexe begründet.

Bevorzugt sind Verbindungen gemäß Formel (1), in denen M für ein tetrakoordiniertes, ein pentakoordiniertes oder ein hexakoordiniertes Übergangsmetall steht, besonders bevorzugt ausgewählt aus der Gruppe bestehend aus Chrom, Molybdän, Wolfram, Rhenium, Ruthenium, Osmium, Rhodium, Iridium, Nickel, Palladium, Platin, Kupfer, Silber und Gold, insbesondere Molybdän, Wolfram, Rhenium, Ruthenium, Osmium, Iridium, Platin, Kupfer und Gold. Ganz besonders bevorzugt sind Iridium und Platin. Die Metalle können dabei in verschiedenen Oxidationsstufen vorliegen. Bevorzugt sind dabei die oben genannten Metalle in den Oxidationsstufen Cr(0), Cr(II), Cr(III), Cr(IV), Cr(VI), Mo(0), Mo(II), Mo(III), Mo(IV), Mo(VI), W(0), W(II), W(III), W(IV), W(VI), Re(I), Re(II), Re(III), Re(IV), Ru(II), Ru(III), Os(II), Os(III), Os(IV), Rh(I), Rh(III), Ir(I), Ir(III), Ir(IV), Ni(0), Ni(II), Ni(IV), Pd(II), Pt(II), Pt(IV), Cu(I), Cu(II), Cu(III), Ag(I), Ag(II), Au(I), Au(III) und Au(V); besonders bevorzugt sind Mo(0), W(0), Re(I), Ru(II), Os(II), Rh(III) und Ir(III), wobei die vorgenannten Metalle die Koordinationszahl 6 aufweisen, Pt(II), welches die Koordinationszahl 4 aufweist, und Cu(I), welches die Koordinationszahl 3 oder 4 aufweist, insbesondere Ir(III) und Pt(II).

In einer bevorzugten Ausführungsform der Erfindung ist M ein tetrakoordiniertes Metall, und der Index n steht für 1 oder 2. Wenn der Index n = 1 ist, sind noch ein bidentater oder zwei monodentate Liganden L', bevorzugt ein bidentater Ligand L', an das Metall M koordiniert. Wenn der Index n = 2 ist, ist der Index m = 0.

In einer weiteren bevorzugten Ausführungsform der Erfindung ist M ein hexakoordiniertes Metall, und der Index n steht für 1, 2 oder 3, bevorzugt für 2 oder 3. Wenn der Index n = 1 ist, sind noch vier monodentate oder zwei bidentate oder ein bidentater und zwei monodentate oder ein tridentater und ein monodentater oder ein tetradentater Ligand L', bevorzugt zwei bidentate Liganden L', an das Metall koordiniert. Wenn der Index n = 2 ist, sind noch ein bidentater oder zwei monodentate Liganden L', bevorzugt ein bidentater Ligand L', an das Metall koordiniert. Wenn der Index n = 3 ist, ist der Index m = 0.

Die Liganden L sind bidentate Liganden, welche über ein Kohlenstoffatom und ein exocyclisches Sauerstoffatom, Schwefelatom oder Stickstoffatom an das Metall M binden.

Die Gruppen der Formel (3) bzw. (4) können in jeder möglichen Position am Liganden L gebunden sein. Bevorzugte Ausführungsformen der Teilstruktur gemäß Formel (2) sind daher die Strukturen der folgenden Formeln (5) bis (17), 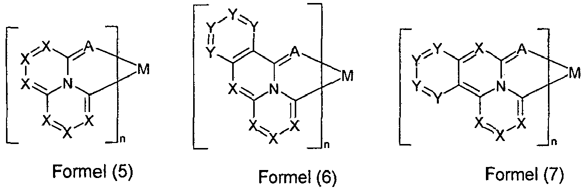 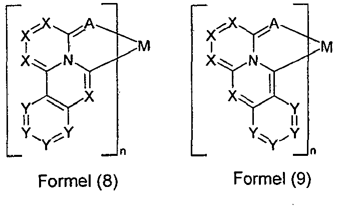 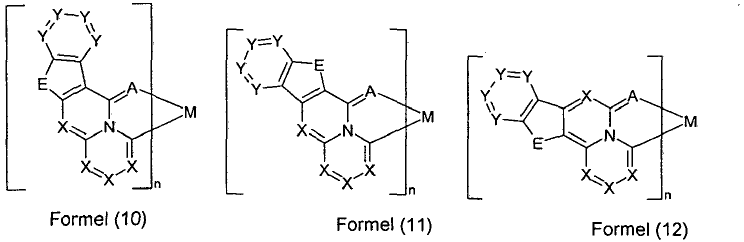 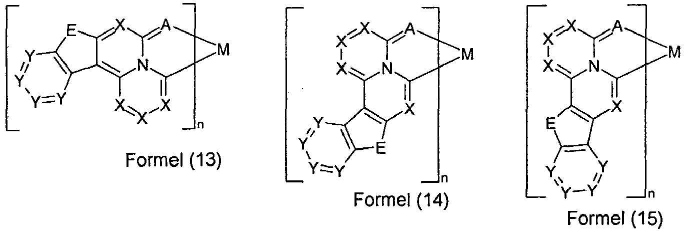 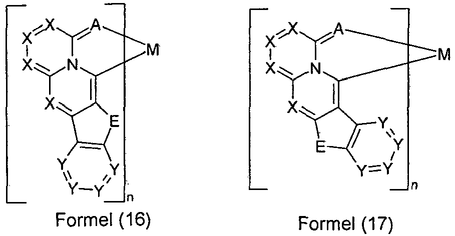 wobei X gleich oder verschieden bei jedem Auftreten für CR oder N steht und die weiteren Symbole und Indizes die oben genannten Bedeutungen aufweisen.

Besonders bevorzugt sind die Strukturen der oben genannten Formeln (5), (7) und (8).

In einer bevorzugten Ausführungsform der Erfindung stehen maximal zwei Gruppen X, besonders bevorzugt maximal eine Gruppe X pro Cyclus für Stickstoff, und die anderen Gruppen X in dem Cyclus stehen für CR.

In einer weiteren bevorzugten Ausführungsform der Erfindung stehen maximal zwei Gruppen Y, besonders bevorzugt maximal eine Gruppe Y, ganz besonders bevorzugt keine Gruppe Y pro Cyclus für Stickstoff, und die weiteren Symbole Y in dem Cyclus stehen für CR.

Ganz besonders bevorzugt stehen maximal eine Gruppe X und eine Gruppe Y für N und die anderen Gruppen X und Y stehen für CR. Insbesondere bevorzugt steht maximal eine Gruppe X für CR und die anderen Gruppen X sowie die Gruppen Y stehen für CR.

Bevorzugte Ausführungsformen der Formeln (5), (7) und (8) sind die Strukturen der folgenden Formeln (5a) bis (5d), (7a) bis (7c) und (8a) bis (8c), 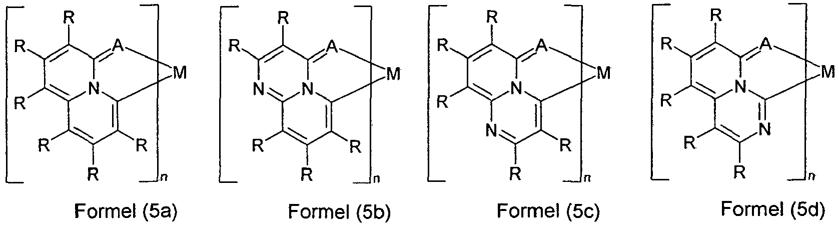 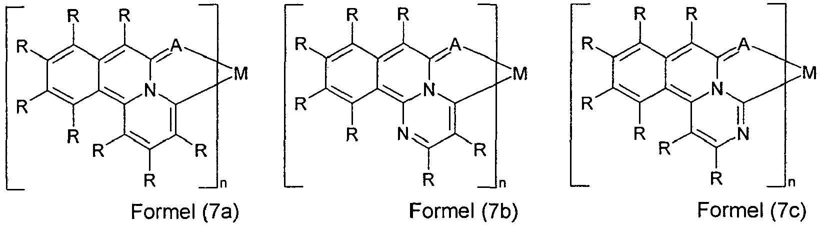 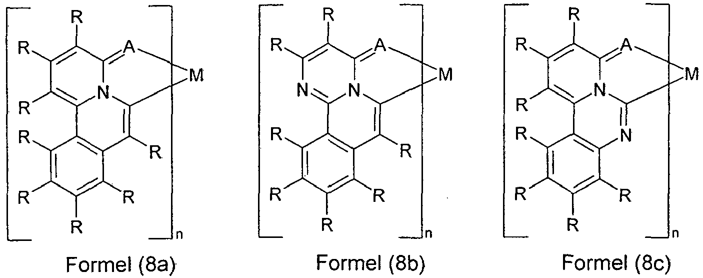 wobei die verwendeten Symbole und Indizes die oben genannten Bedeutungen aufweisen.

In einer bevorzugten Ausführungsform der Erfindung steht die koordinierende Gruppe A in den Teilstrukturen der Formeln (2) und (5) bis (17) und den bevorzugten Ausführungsformen für O oder S, besonders bevorzugt für O.

Wenn in dem Liganden L ein oder mehrere Gruppen X und/oder Y für N stehen, so ist es bevorzugt, wenn benachbart zu diesen N-Atom mindestens ein Substituent R ungleich H oder D gebunden ist, insbesondere ein sterisch anspruchsvoller Substituent. Diese Bevorzugung ist damit zu begründen, dass dadurch das entsprechende Stickstoffatom sterisch abgeschirmt ist und somit nicht mehr für eine Koordination an das Metall M zur Verfügung steht. Dies führt zur selektiveren Bildung der erfindungsgemäßen Metallkomplexe und somit zu höheren Ausbeuten und größeren Reinheiten.

Sterisch anspruchsvolle Substituenten sind beispielsweise Alkylgruppen, insbesondere verzweigte und cyclische Alkylgruppen, Alkoxygruppen, substituierte Aminogruppen, Aralkylgruppen und aromatische und heteroaromatische Ringsysteme, wie sie jeweils oben bei der Definition von R definiert sind.

Wenn dieser Rest R für eine Alkylgruppe steht, dann weist diese Alkylgruppe bevorzugt 3 bis 10 C-Atome, insbesondere 4 bis 8 C-Atome auf. Bevorzugt handelt es sich weiterhin um eine sekundäre oder tertiäre Alkylgruppe, bei der das sekundäre oder tertiäre C-Atom entweder direkt an den Liganden gebunden ist oder über eine CH₂-Gruppe an den Liganden gebunden ist. Besonders bevorzugt ist diese Alkylgruppe ausgewählt aus den Strukturen der folgenden Formeln (R-1) bis (R-33), wobei jeweils auch die Anknüpfung dieser Gruppen an den Liganden mit eingezeichnet ist: 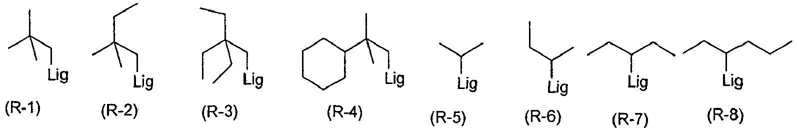 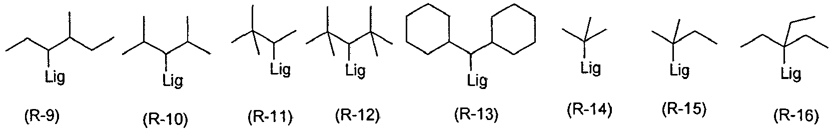 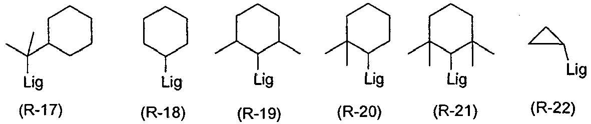 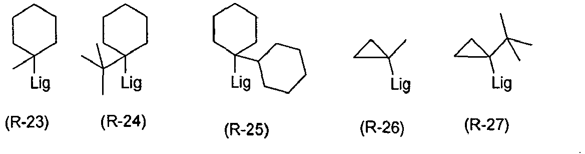 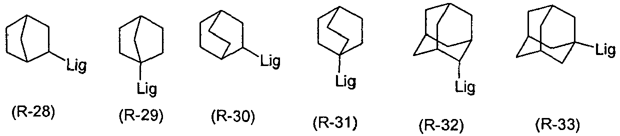 wobei Lig die Anknüpfung der Alkylgruppe an den Liganden kennzeichnet.

Wenn R für eine Alkoxygruppe steht, dann weist diese Alkoxygruppe bevorzugt 3 bis 10 C-Atome auf. Bevorzugt ist diese Alkoxygruppe ausgewählt aus den Strukturen der folgenden Formeln (R-34) bis (R-47), wobei jeweils auch die Anknüpfung dieser Gruppen an den Liganden mit eingezeichnet ist: 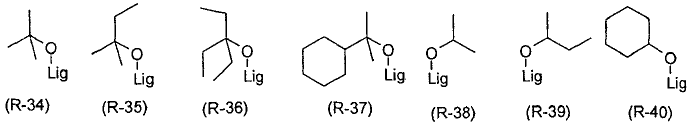 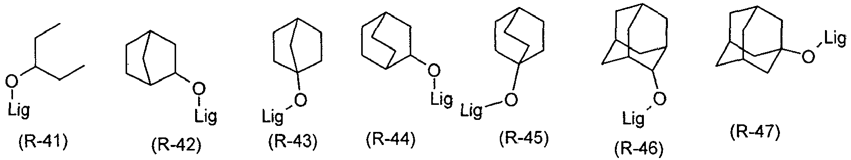 wobei Lig die Anknüpfung der Alkylgruppe an den Liganden kennzeichnet.

Wenn R für eine Dialkylaminogruppe steht, dann weist jede dieser Alkylgruppen bevorzugt 1 bis 8 C-Atome auf, besonders bevorzugt 1 bis 6 C-Atome. Beispiele für geeignete Alkylgruppen sind Methyl, Ethyl oder die oben als Gruppen (R-1) bis (R-33) aufgeführten Strukturen. Besonders bevorzugt ist die Dialkylaminogruppe ausgewählt aus den Strukturen der folgenden Formeln (R-48) bis (R-55), wobei jeweils auch die Anknüpfung dieser Gruppen an den Liganden mit eingezeichnet ist: 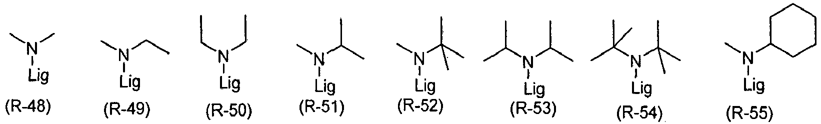 wobei Lig die Anknüpfung der Alkylgruppe an den Liganden kennzeichnet.

Wenn R für eine Aralkylgruppe steht, dann ist diese Aralkylgruppe bevorzugt ausgewählt aus den Strukturen der folgenden Formeln (R-56) bis (R-69), wobei jeweils auch die Anknüpfung dieser Gruppen an den Liganden eingezeichnet ist: 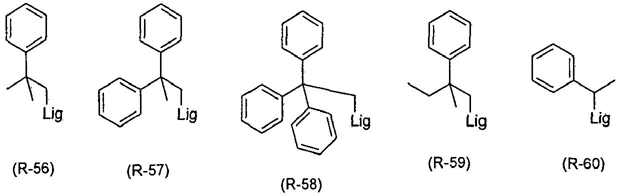 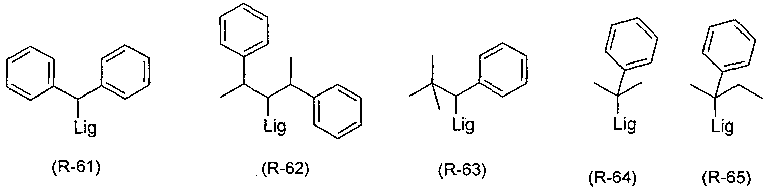 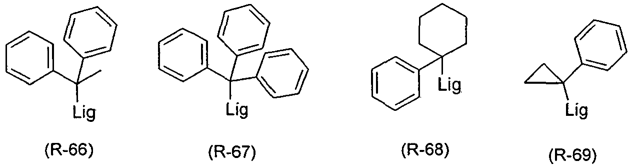 wobei Lig die Anknüpfung der Aralkylgruppe an den Liganden kennzeichnet und die Phenylgruppen jeweils durch einen oder mehrere Reste R¹ substituiert sein können.

Die Alkyl-, Alkoxy-, Dialkylamino- und Aralkylgruppen können, je nach genauer Struktur, auch ein oder mehrere Stereozentren aufweisen. Da es sich bei der Grundstruktur des Komplexes auch um eine chirale Struktur handeln kann, ist die Bildung von Diastereomeren möglich, insbesondere auch, wenn mehrere solcher Alkyl-, Alkoxy-, Dialkylamino- und Aralkylgruppen mit Stereozentren vorliegen. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Wenn R für ein aromatisches bzw. heteroaromatisches Ringsystem steht, dann weist dieses aromatische bzw. heteroaromatische Ringsystem bevorzugt 5 bis 30 aromatische Ringatome auf, besonders bevorzugt 5 bis 24 aromatische Ringatome. Weiterhin enthält dieses aromatische bzw. heteroaromatische Ringsystem bevorzugt keine Aryl- bzw. Heteroarylgruppen, in denen mehr als zwei aromatische Sechsringe direkt aneinander kondensiert sind. Besonders bevorzugt enthält das aromatische bzw. heteroaromatische Ringsystem überhaupt keine kondensierten Aryl- bzw. Heteroarylgruppen, und ganz besonders bevorzugt enthält es nur Phenylgruppen. Dabei ist das aromatische Ringsystem bevorzugt ausgewählt aus den Strukturen der folgenden Formeln (R-70) bis (R-84), wobei jeweils auch die Anknüpfung dieser Gruppen an den Liganden eingezeichnet ist: 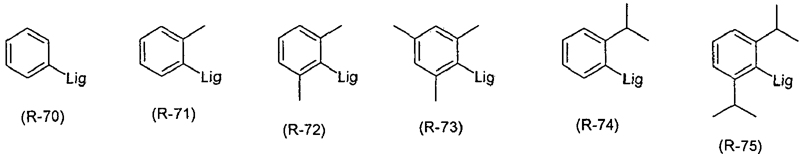 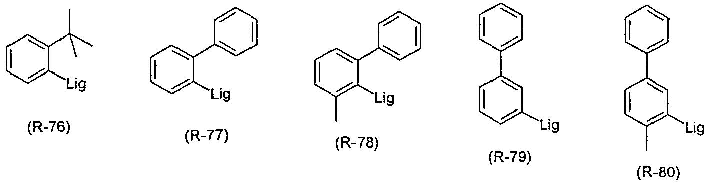 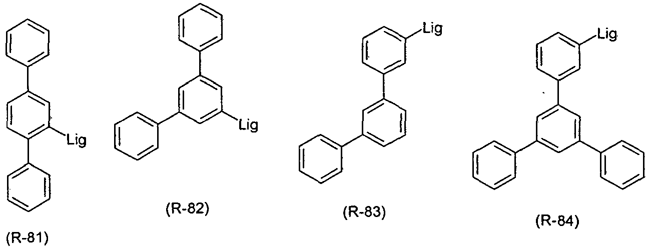 wobei Lig die Anknüpfung des aromatischen oder heteroaromatischen Ringsystems an den Liganden kennzeichnet und die Phenylgruppen jeweils durch einen oder mehrere Reste R¹ substituiert sein können.

Weiterhin ist das heteroaromatische Ringsystem bevorzugt ausgewählt aus den Strukturen der folgenden Formeln (R-85) bis (R-112), wobei jeweils auch die Anknüpfung dieser Gruppen an den Liganden eingezeichnet ist: 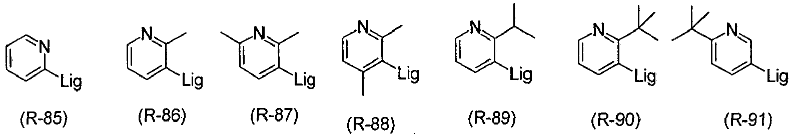 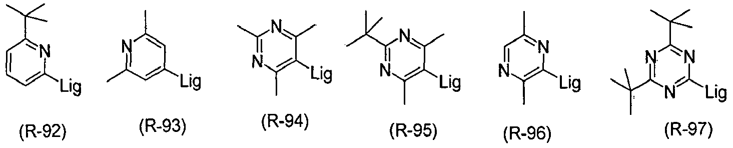 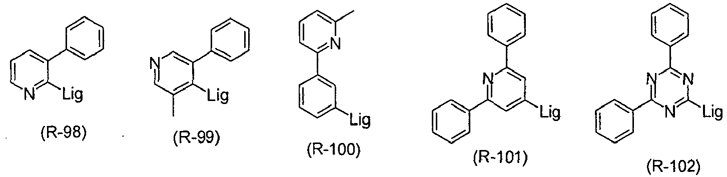 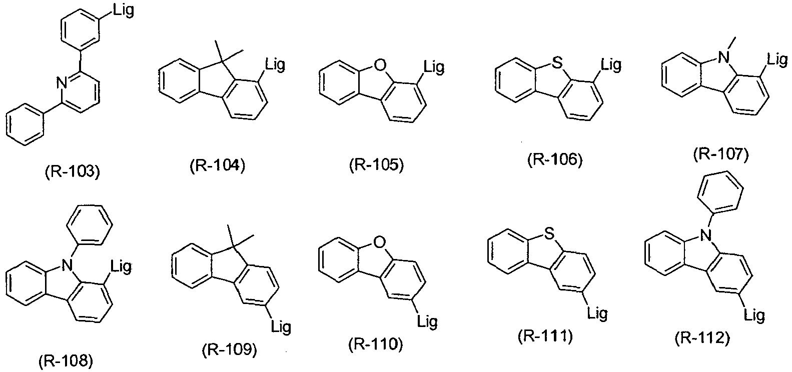 wobei Lig die Anknüpfung des aromatischen oder heteroaromatischen Ringsystems an den Liganden kennzeichnet und die aromatischen und heteroaromatischen Gruppen jeweils durch einen oder mehrere Reste R¹ substituiert sein können.

Weiterhin kann es bevorzugt sein, dass der Ligand L zwei benachbarte Kohlenstoffatome aufweist, die jeweils mit Resten R substituiert sind, wobei die jeweiligen Reste R zusammen mit den C-Atomen einen Ring der folgenden Formel (18), (19), (20) oder (20a) bis (20d) aufspannen, 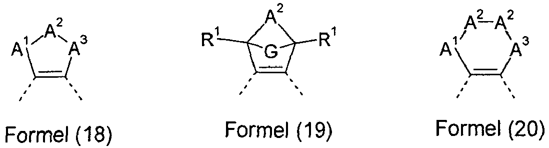 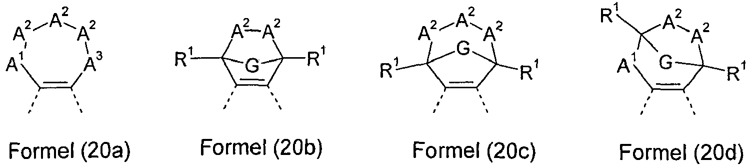 wobei R¹ und R² die oben genannten Bedeutungen aufweisen, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, O, S, NR³ oder C(=O);
- A²: ist gleich oder verschieden bei jedem Auftreten C(R¹)₂, O, S, NR³ oder C(=O); oder zwei benachbarte Gruppen A² zusammen stehen in Formel (20) für eine Gruppe der folgenden Formel (21) oder (22), 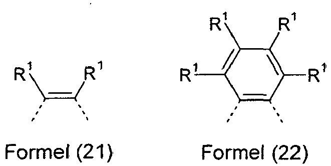
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten F, eine geradkettige Alkyl- oder Alkoxygruppe mit 1 bis 20 C-Atomen, eine verzweigte oder cyclische Alkyl- oder Alkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³ miteinander ein aliphatisches oder aromatisches Ringsystem bilden; weiterhin kann R³ mit einem benachbarten Rest R oder R¹ ein aliphatisches Ringsystem bilden;
mit der Maßgabe, dass in A¹-A²-A³ A¹-(A²)₂-A³ A¹-(A²)₃-A³ nicht zwei Heteroatome direkt aneinander gebunden sind.

Wenn zwei Reste R³, die an dasselbe Kohlenstoffatom gebunden sind, miteinander ein Ringsystem bilden, entsteht ein Spirosystem.

Die Gruppen der Formel (18), (19), (20) bzw. (20a) bis (20d) sind auch bevorzugte Gruppen, wenn sie benachbart zu einem N-Atom im Liganden gebunden sind.

Wesentlich bei den Gruppen der Formeln (18), (19), (20) und (20a) bis (20d) ist, dass diese keine aziden benzylischen Protonen aufweisen. Unter benzylischen Protonen werden Protonen verstanden, die an ein Kohlenstoffatom binden, welches direkt an den heteroaromatischen Liganden gebunden sind. Die Abwesenheit von aziden benzylischen Protonen wird in Formel (18), (20) und (20a) dadurch erreicht, dass A¹ und A³, wenn diese für C(R³)₂ stehen, so definiert sind, dass R³ ungleich Wasserstoff ist. Die Abwesenheit von aziden benzylischen Protonen ist in Formel (19), (20b) und (20c) automatisch dadurch erreicht, dass es sich dabei um eine bicyclische Struktur handelt. Aufgrund der starren räumlichen Anordnung ist R¹, wenn es für H steht, deutlich weniger azide als benzylische Protonen, da das korrespondierende Anion der bicyclischen Struktur nicht mesomeriestabilisiert ist. Auch wenn R¹ in Formel (19), (20b), (20c) und (20d) für H steht, handelt es sich dabei um ein nicht-azides Proton im Sinne der vorliegenden Anmeldung.

In einer bevorzugten Ausführungsform der Struktur gemäß Formel (18) steht maximal eine der Gruppen A¹, A² und A³ für ein Heteroatom, insbesondere für O oder NR³, und die anderen beiden Gruppen stehen für C(R³)₂ bzw. C(R¹)₂ oder A¹ und A³ stehen gleich oder verschieden bei jedem Auftreten für O oder NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂. Bevorzugte Ausführungsformen der Formel (18) sind somit die Strukturen der Formel (18-A), (18-B), (18-C) und (18-D), und eine besonders bevorzugte Ausführungsform der Formel (18-A) ist die Struktur der Formel (18-E), 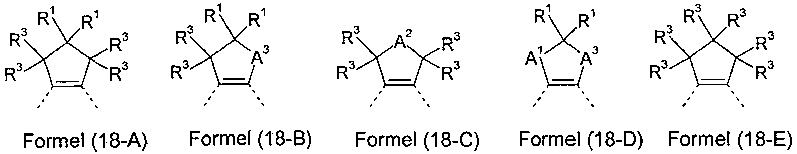 wobei R¹ und R³ die oben genannten Bedeutungen aufweisen und A¹, A² und A³ gleich oder verschieden bei jedem Auftreten für O oder NR³ steht.

In einer bevorzugten Ausführungsform der Struktur gemäß Formel (19) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (19) sind somit eine Strukturen der Formel (19-A) und (19-B), und eine besonders bevorzugte Ausführungsform der Formel (19-A) ist eine Struktur der Formel (19-C), 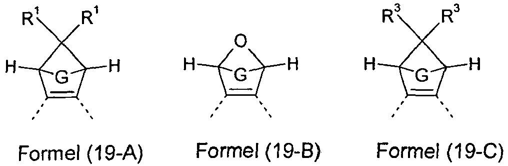 wobei die verwendeten Symbole die oben genannten Bedeutungen aufweisen.

Weiterhin bevorzugt steht die Gruppe G in den Formeln (19), (19-A), (19-B) und (19-C) für eine Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, also eine Gruppe -C(R²)₂-C(R²)₂-, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer bevorzugten Ausführungsform der Struktur gemäß Formel (20) steht maximal eine der Gruppen A¹, A² und A³ für ein Heteroatom, insbesondere für O oder NR³, und die anderen Gruppen stehen für C(R³)₂ bzw. C(R¹)₂ oder A¹ und A³ stehen gleich oder verschieden bei jedem Auftreten für O oder NR³ und A² steht gleich oder verschieden bei jedem Auftreten für C(R¹)₂. In einer besonders bevorzugten Ausführungsform der Erfindung stehen A¹ und A³ gleich oder verschieden bei jedem Auftreten für C(R³)₂ und A² steht gleich oder verschieden bei jedem Auftreten für C(R¹)₂ und besonders bevorzugt für C(R³)₂. Bevorzugte Ausführungsformen der Formel (20) sind somit die Strukturen der Formel (20-A) bis (20-J), 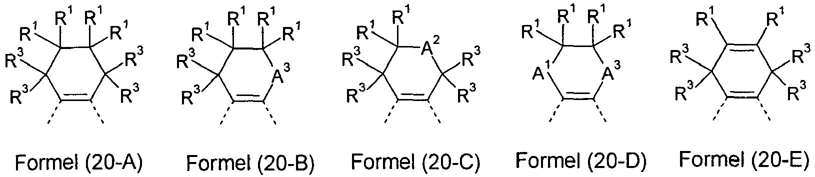 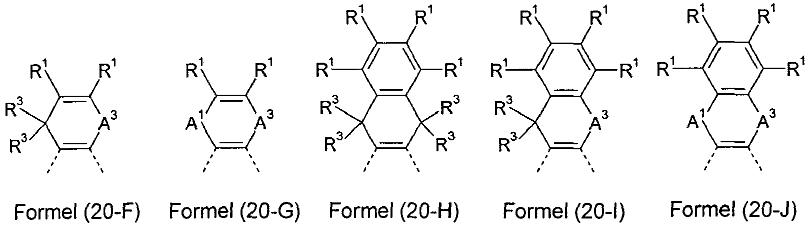 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (20a) sind die Strukturen der folgenden Formeln (20a-A) bis (20a-E), 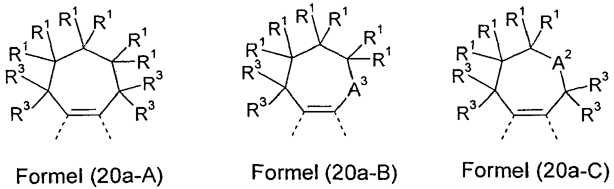 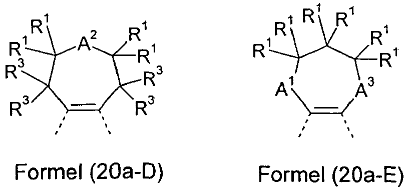 wobei R¹ und R³ die oben genannten Bedeutungen aufweisen und A¹, A² und A³ gleich oder verschieden bei jedem Auftreten für O oder NR³ steht.

In einer bevorzugten Ausführungsform der Struktur gemäß Formel (20b), (20c) und (20d) stehen die Reste R¹, die an den Brückenkopf gebunden sind, für H, D, F oder CH₃ besonders bevorzugt für H. Weiterhin bevorzugt steht A² für C(R¹)₂. Bevorzugte Ausführungsformen der Formel (20b), (20c) und (20d) sind somit die Strukturen der Formeln (20b-A), (20c-A) und (20dA), 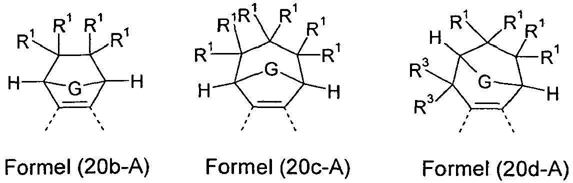 wobei die verwendeten Symbole die oben genannten Bedeutungen aufweisen.

In einer weiteren bevorzugten Ausführungsform der Erfindung steht R³ in den Gruppen der Formel (18), (19), (20) und (20a) bis (20d) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (18), (19), (20) und (20a) bis (20d) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (18) sind die im Folgenden aufgeführten Gruppen (18-1) bis (18-69):

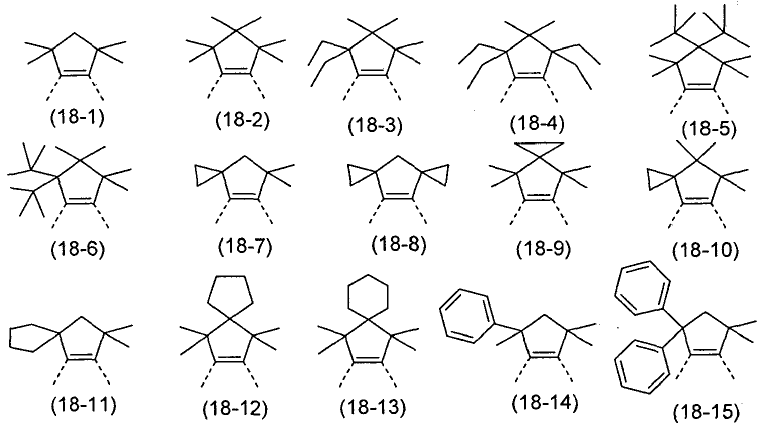

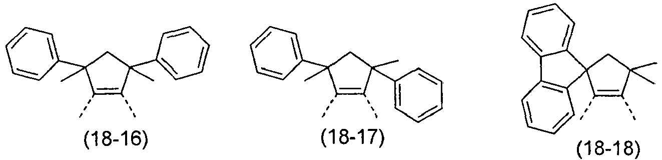

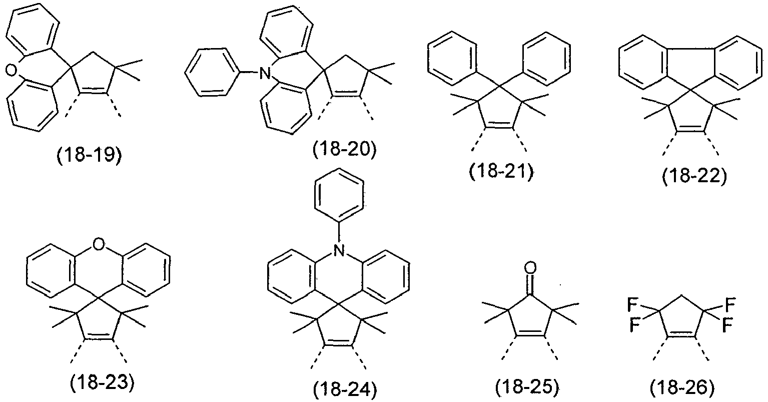

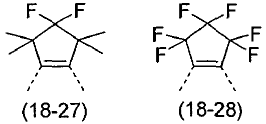

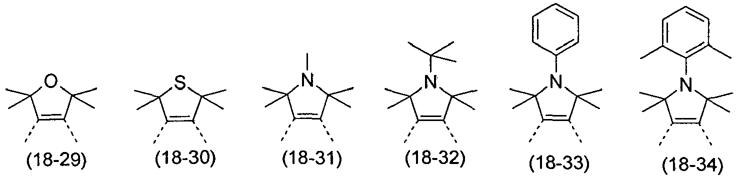

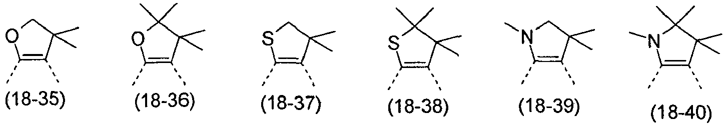

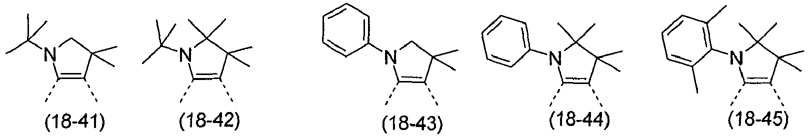

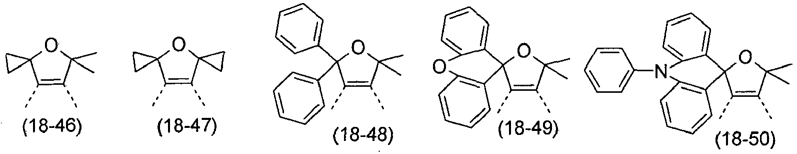

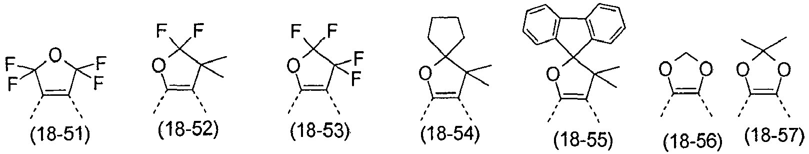

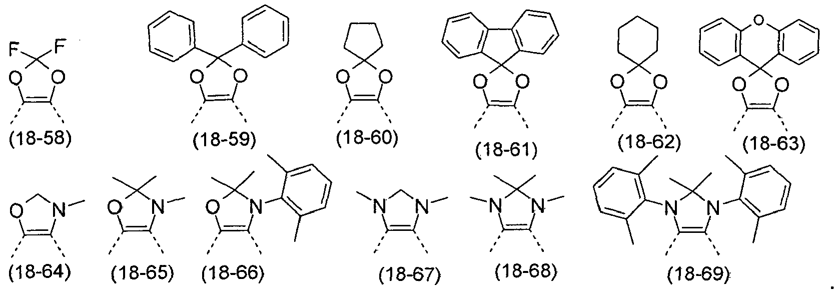

Beispiele für besonders geeignete Gruppen der Formel (19) sind die im Folgenden aufgeführten Gruppen (19-1) bis (19-21):

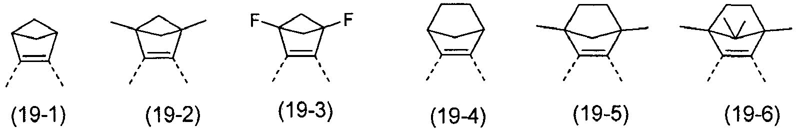

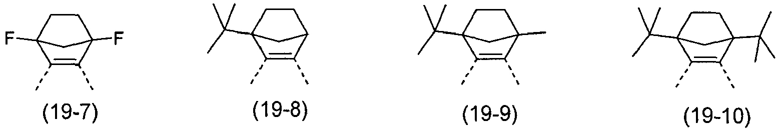

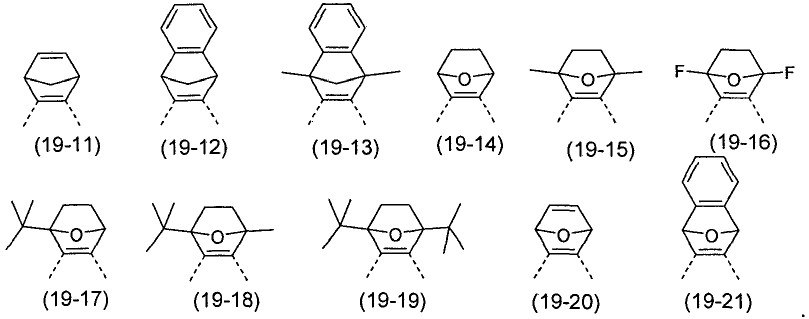

Beispiele für besonders geeignete Gruppen der Formel (20) sind die im Folgenden aufgeführten Gruppen (20-1) bis (20-30):

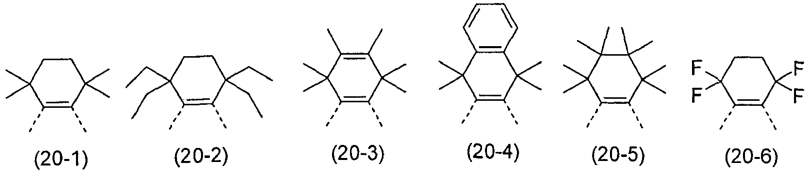

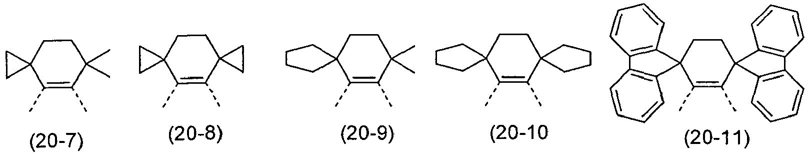

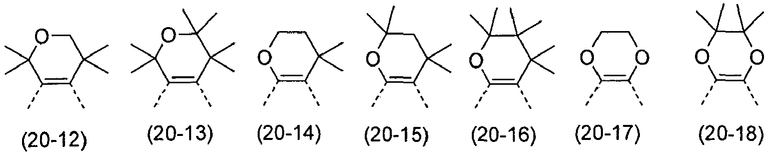

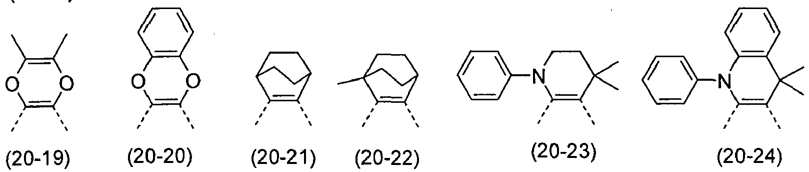

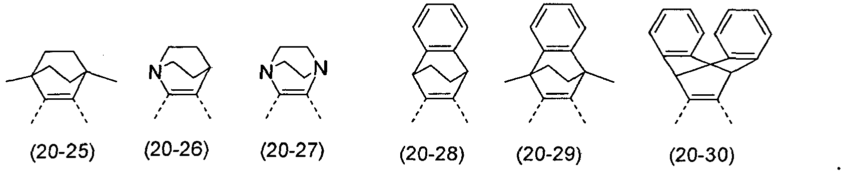

Beispiele für besonders geeignete Gruppen der Formel (20a), (20c) und (20d) sind die im Folgenden aufgeführten Gruppen:

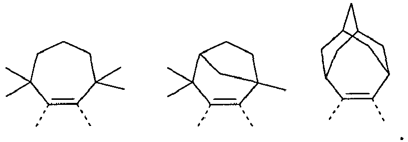

Wenn in der Teilstruktur der Formel (2) weitere oder andere Reste R, die nicht den oben genannten Resten entsprechen, gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Weiterhin ist es möglich, dass einer der Substituenten R in den Teilstrukturen der Formel (2) oder (5) bis (17) eine koordinierende Gruppe darstellt, die ebenfalls an das Metall M koordiniert. Bevorzugte koordinierende Gruppen R sind Aryl- bzw. Heteroarylgruppen, beispielsweise Phenyl oder Pyridyl, Aryl- oder Alkylcyanide, Aryl- oder Alkylisocyanide, Amine oder Amide, Alkohole oder Alkoholate, Thioalkohole oder Thioalkoholate, Phosphine, Phosphite, Carbonylfunktionen, Carboxylate, Carbamide oder Aryl- oder Alkylacetylide. Hier sind beispielsweise die Teilstrukturen M(L)ₙ der folgenden Formel (23) zugänglich, 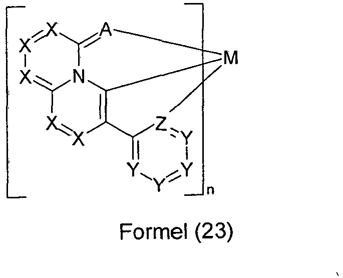 wobei die verwendeten Symbole und Indizes die oben genannten Bedeutungen haben und Z für C oder N steht. Ganz analog zu diesen Strukturen sind auch weitere Strukturen mit tridentaten oder tetradentaten Liganden möglich.

Wie oben beschrieben, kann auch statt einem der Reste R in Formel (2) eine verbrückende Einheit V vorhanden sein, die diesen Liganden L mit einem oder mehreren weiteren Liganden L bzw. L' verknüpft. In einer bevorzugten Ausführungsform der Erfindung ist statt einem der Reste R eine verbrückende Einheit V vorhanden, so dass die Liganden dreizähnigen oder mehrzähnigen oder polypodalen Charakter aufweisen. Es können auch zwei solcher verbrückenden Einheiten V vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (24) bis (28), 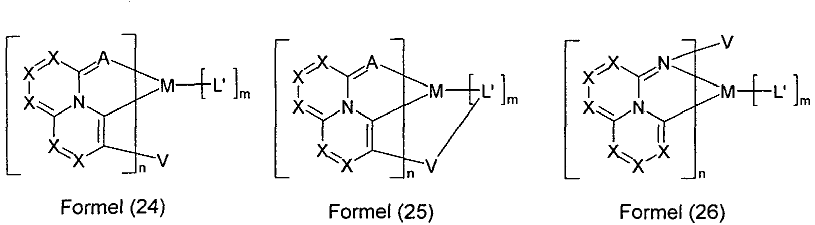 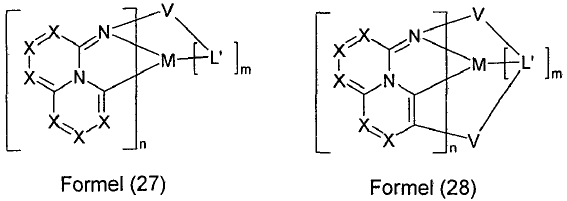 wobei die verwendeten Symbole die oben genannten Bedeutungen aufweisen, wobei n in den Formeln (24), (26) und (28) 2 oder 3 ist und V bevorzugt eine verbrückende Einheit darstellt, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch durch einen oder mehrere Reste R¹ substituiert sein. Weiterhin kann die verbrückende Einheit V auch unsymmetrisch aufgebaut sein, d. h. die Verknüpfung von V zu L bzw. L' muss nicht identisch sein. Die verbrückende Einheit V kann neutral, einfach, zweifach oder dreifach negativ oder einfach, zweifach oder dreifach positiv geladen sein. Bevorzugt ist V neutral oder einfach negativ oder einfach positiv geladen. Dabei wird die Ladung von V bevorzugt so gewählt, dass insgesamt ein neutraler Komplex entsteht.

Wenn V drei Liganden L miteinander bzw. zwei Liganden L mit L' oder einen Liganden L mit zwei Liganden L' verbrückt, ist V bevorzugt gleich oder verschieden bei jedem Auftreten gewählt aus der Gruppe bestehend aus B, B(R¹)⁻, B(C(R¹)₂)₃, (R¹)B(C(R¹)₂)₃⁻, B(O)₃, (R¹)B(O)₃⁻, B(C(R¹)₂C(R¹)₂)₃, (R¹)B(C(R¹)₂C(R¹)₂)₃⁻, B(C(R¹)₂O)₃, (R¹)B(C(R¹)₂O)₃⁻, B(OC(R¹)₂)₃, (R¹)B(OC(R¹)₂)₃⁻, C(R¹), CO⁻, CN(R¹)₂, (R¹)C(C(R¹)₂)₃, (R¹)C(O)₃, (R¹)C(C(R¹)₂C(R¹)₂)₃, (R¹)C(C(R¹)₂O)₃, (R¹)C(OC(R¹)₂)₃, (R¹)C(Si(R¹)₂)₃, (R¹)C(Si(R¹)₂C(R¹)₂)₃, (R¹)C(C(R¹)₂Si(R¹)₂)₃, (R¹)C(Si(R¹)₂Si(R¹)₂)₃, Si(R¹), (R¹)Si(C(R¹)₂)₃, (R¹)Si(O)₃, (R¹)Si(C(R¹)₂C(R¹)₂)₃, (R¹)Si(OC(R¹)₂)₃, (R¹)Si(C(R¹)₂O)₃, (R¹)Si(Si(R¹)₂)₃, (R¹)Si(Si(R¹)₂C(R¹)₂)₃, (R¹)Si(C(R¹)₂Si(R¹)₂)₃, (R¹)Si(Si(R¹)₂Si(R¹)₂)₃, N, NO, N(R¹)⁺, N(C(R¹)₂)₃, (R¹)N(C(R¹)₂)₃⁺, N(C=O)₃, N(C(R¹)₂C(R¹)₂)₃, (R¹)N(C(R¹)₂C(R¹)₂)⁺, P, P(R¹)⁺, PO, PS, PSe, PTe, P(O)₃, PO(O)₃, P(OC(R¹)₂)₃, PO(OC(R¹)₂)₃, P(C(R¹)₂)₃, P(R¹)(C(R¹)₂)₃⁺, PO(C(R¹)₂)₃, P(C(R¹)₂C(R¹)₂)₃, P(R¹)(C(R¹)₂C(R¹)₂)₃⁺, PO(C(R¹)₂C(R¹)₂)₃, S⁺, S(C(R¹)₂)₃⁺, S(C(R¹)₂C(R¹)₂)₃⁺,
oder eine Einheit gemäß Formel (29), (30), (31) oder (32), 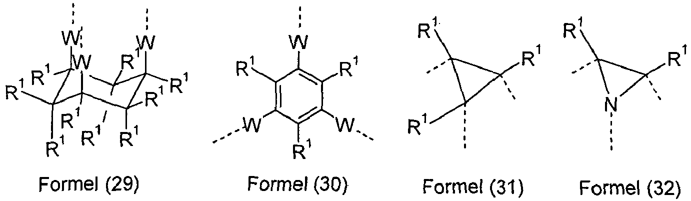 wobei die gestrichelten Bindungen jeweils die Bindung zu den Teilliganden L bzw. L' andeuten und W gleich oder verschieden bei jedem Auftreten ausgewählt ist aus der Gruppe bestehend aus einer Einfachbindung, O, S, S(=O), S(=O)₂, NR¹, PR¹, P(=O)R¹, P(=NR¹), C(R¹)₂, C(=O), C(=NR¹), C(=C(R¹)₂), Si(R¹)₂ oder BR¹. Die weiteren verwendeten Symbole haben die oben genannten Bedeutungen.

Wenn V zwei Liganden L miteinander bzw. einen Liganden L mit L' verbrückt, ist V bevorzugt gleich oder verschieden bei jedem Auftreten gewählt aus der Gruppe bestehend aus BR¹, B(R¹)₂⁻, C(R¹)₂, C(=O), Si(R¹)₂, NR¹, PR¹, P(R¹)₂⁺, P(=O)(R¹), P(=S)(R¹), O, S oder eine Einheit gemäß Formel (33) bis (42), 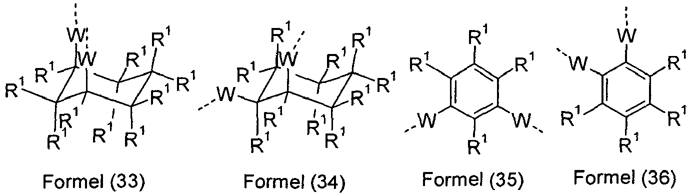 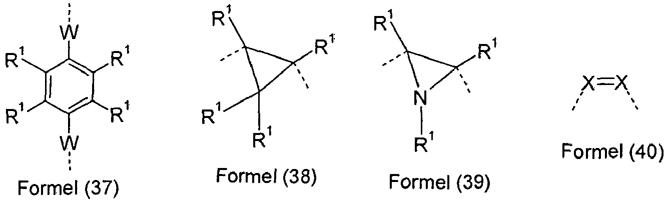 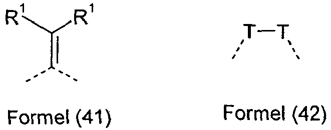 wobei die gestrichelten Bindungen jeweils die Bindung zu den Teilliganden L bzw. L' andeuten, T bei jedem Auftreten gleich oder verschieden für C(R¹)₂, N(R¹), O oder S steht und die weiteren verwendeten Symbole jeweils die oben aufgeführten Bedeutungen haben.

Im Folgenden werden bevorzugte Liganden L' beschrieben, wie sie in Formel (1) vorkommen. Entsprechend können auch die Ligandengruppen L' gewählt sein, wenn diese über eine verbrückende Einheit V an L gebunden sind.

Die Liganden L' sind bevorzugt gleich oder verschieden bei jedem Auftreten neutrale, monoanionische, dianionische oder trianionische Liganden, besonders bevorzugt neutrale oder monoanionische Liganden. Sie können monodentat, bidentat, tridentat oder tetradentat sein und sind bevorzugt bidentat, weisen also bevorzugt zwei Koordinationsstellen auf. Wie oben beschrieben, können die Liganden L' auch über eine verbrückende Gruppe V an L gebunden sein.

Bevorzugte neutrale, monodentate Liganden L' sind gleich oder verschieden bei jedem Auftreten ausgewählt aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert-*butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L' sind gleich oder verschieden bei jedem Auftreten ausgewählt aus Hydrid, Deuterid, den Halogeniden F⁻, Cl⁻, Br⁻ und I⁻, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert-*Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Bevorzugte di- bzw. trianionische Liganden sind gleich oder verschieden bei jedem Auftreten O²⁻, S²⁻, Carbide, welche zu einer Koordination der Form R-C≡M führen, und Nitrene, welche zu einer Koordination der Form R-N=M führen, wobei R allgemein für einen Substituenten steht, und N³⁻.

Bevorzugte neutrale oder mono- oder dianionische, bidentate oder höherdentate Liganden L' sind gleich oder verschieden bei jedem Auftreten ausgewählt aus Diaminen, wie z. B. Ethylendiamin, N,N,N',N'-Tetramethylethylendiamin, Propylendiamin, N,N,N',N'-Tetramethylpropylendi-amin, cis- oder trans-Diaminocyclohexan, cis- oder trans-N,N,N',N'-Tetramethyldiaminocyclohexan, Iminen, wie z. B. 2-[1-(Phenylimino)ethyl]-pyridin, 2-[1-(2-Methylphenylimino)ethyl]pyridin, 2-[1-(2,6-Di-*iso*-propyl-phenylimino)ethyl]pyridin, 2-[1-(Methylimino)ethyl]pyridin, 2-[1-(ethylimino)-ethyl]pyridin, 2-[1-(*Iso*-Propylimino)ethyl]pyridin, 2-[1-(*Tert*-Butylimino)-ethyl]pyridin, Diminen, wie z. B. 1,2-Bis(methylimino)ethan, 1,2-Bis(ethyl-imino)ethan, 1,2-Bis(*iso*-propylimino)ethan, 1,2-Bis(*tert*-butylimino)ethan, 2,3-Bis(methylimino)butan, 2,3-Bis(ethylimino)butan, 2,3-Bis(*iso*-propyl-imino)butan, 2,3-Bis(*tert*-butylimino)butan, 1,2-Bis(phenylimino)ethan, 1,2-Bis(2-methylphenylimino)ethan, 1,2-Bis(2,6-di-*iso*-propylphenylimino)-ethan, 1,2-Bis(2,6-di-*tert*-butylphenylimino)ethan, 2,3-Bis(phenylimino)-butan, 2,3-Bis(2-methylphenylimino)butan, 2,3-Bis(2,6-di-*iso-*propylphenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenyl-phosphino)ethan, Bis(diphenylphosphino)propan, Bis(diphenylphosphino)-butan, Bis(dimethylphosphino)methan, Bis(dimethylphosphino)ethan, Bis-(dimethylphosphino)propan, Bis(diethylphosphino)methan, Bis(diethyl-phosphino)ethan, Bis(diethylphosphino)propan, Bis(di-*tert*-butylphosphino)-methan, Bis(di-*tert*-butylphosphino)ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 2,2,6,6-Tetramethyl-3,5-heptandion, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugte tridentate Liganden sind Borate stickstoffhaltiger Heterocyclen, wie z. B. Tetrakis(1-imidazolyl)borat und Tetrakis(1-pyrazolyl)borat.

Bevorzugt sind weiterhin gleich oder verschieden bei jedem Auftreten bidentate monoanionische Liganden L', welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (43) bis (65) dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet. Der Ligand L' kann dann aus den Gruppen der Formeln (43) bis (65) gebildet werden, indem diese Gruppen jeweils an der durch # gekennzeichneten Position aneinander binden. Die Position, an der die Gruppen an das Metall koordinieren, sind durch * gekennzeichnet. Diese Gruppen können auch über eine oder zwei verbrückende Einheiten V an den Liganden L gebunden sein.

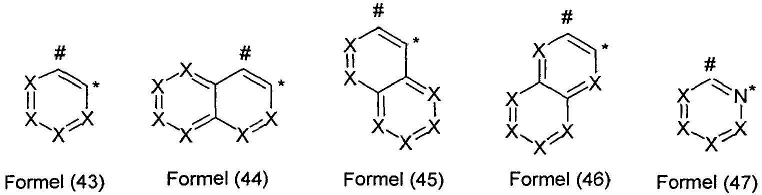

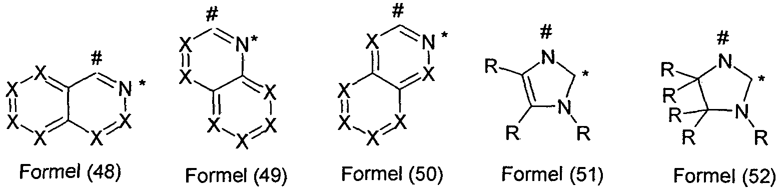

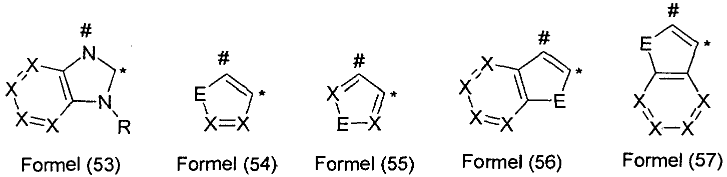

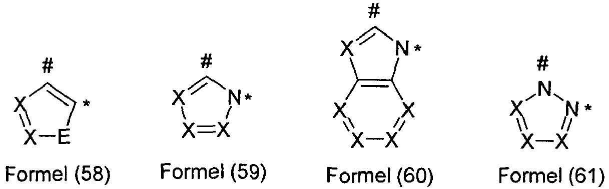

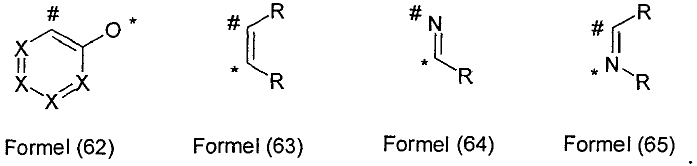

Dabei haben die verwendeten Symbole dieselbe Bedeutung wie oben beschrieben, und bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Ebenfalls bevorzugte Liganden L' sind η⁵-Cyclopentadienyl, η⁵-Pentamethylcyclopentadienyl, η⁶-Benzol oder η⁷-Cycloheptatrienyl, welche jeweils durch einen oder mehrere Reste R¹ substituiert sein können.

Ebenfalls bevorzugte Liganden L' sind 1,3,5-cis-Cyclohexanderivate, insbesondere der Formel (66), 1,1,1-Tri(methylen)methanderivate, insbesondere der Formel (67) und 1,1,1-trisubstituierte Methane, insbesondere der Formel (68) und (69), 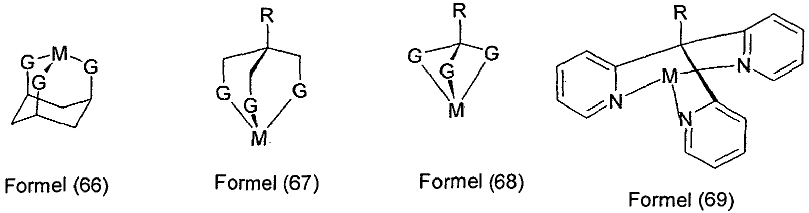 wobei in den Formeln jeweils die Koordination an das Metall M dargestellt ist, R die oben genannte Bedeutung hat und G, gleich oder verschieden bei jedem Auftreten, für O⁻, S⁻, COO⁻, P(R¹)₂ oder N(R¹)₂ steht.

Bevorzugte Reste R in den oben aufgeführten Strukturen der Formeln (43) bis (69), welche als Substituenten an X vorhanden sind, sind bei jedem Auftreten gleich oder verschieden ausgewählt aus der Gruppe bestehend aus H, D, F, Br, N(R¹)₂, CN, B(OR¹)₂, C(=O)R¹, P(=O)(R¹)₂, einer geradkettige Alkylgruppe mit 1 bis 10 C-Atomen oder einer geradkettige Alkenylgruppe mit 2 bis 10 C-Atomen oder einer verzweigten oder cyclischen Alkyl-, Alkenyl- oder Alkinylgruppe mit 3 bis 10 C-Atomen, die jeweils mit einem oder mehreren Resten R¹ substituiert sein kann, wobei ein oder mehrere H-Atome durch D, F oder CN ersetzt sein können, oder ein aromatisches oder heteroaromatisches Ringsystem mit 5 bis 14 aromatischen Ringatomen, das jeweils durch einen oder mehrere Reste R¹ substituiert sein kann; dabei können mehrere benachbarte Reste R auch miteinander ein mono- oder polycyclisches, aliphatisches, aromatisches und/oder benzoannelliertes Ringsystem bilden. Besonders bevorzugte Reste R sind bei jedem Auftreten gleich oder verschieden ausgewählt aus der Gruppe bestehend aus H, F, Br, CN, B(OR¹)₂, einer geradkettige Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch F ersetzt sein können, oder ein aromatisches oder heteroaromatisches Ringsystem mit 5 bis 12 aromatischen Ringatomen, das jeweils durch einen oder mehrere Reste R¹ substituiert sein kann; dabei können mehrere benachbarte Reste R auch miteinander ein mono- oder polycyclisches, aliphatisches, aromatisches und/oder benzoannelliertes Ringsystem bilden.

Die erfindungsgemäßen Komplexe können facial bzw. pseudofacial sein, oder sie können meridional bzw. pseudomeridional sein.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der Metallkomplex-Verbindungen gemäß Formel (1) durch Umsetzung der entsprechenden freien Liganden mit Metallalkoholaten der Formel (70), mit Metallketoketonaten der Formel (71), mit Metallhalogeniden der Formel (72) oder mit dimeren Metallkomplexen der Formel (73),

M(OR¹)ₙ Formel (70)

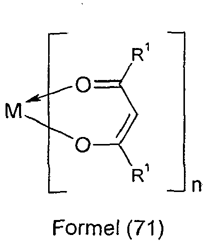

MHalₙ Formel (72)

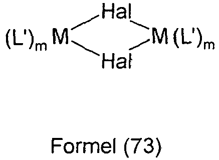

wobei die Symbole und Indizes M, L', m, n und R¹ die oben angegebenen Bedeutungen haben und Hal = F, Cl, Br oder I ist.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 04/085449 offenbart. Besonders geeignet ist [IrCl₂(acac)₂]⁻, beispielsweise Na[IrCl₂(acac)₂]. Weitere besonders geeignete Iridiumedukte sind Iridium(III)-tris(acetylacetonat) und Iridium(III)-tris(2,2,6,6-tetramethyl-3,5-heptandionat).

Die Synthese der Komplexe wird bevorzugt durchgeführt wie in WO 02/060910 und in WO 04/085449 beschrieben. Heteroleptische Komplexe können beispielsweise auch gemäß WO 05/042548 synthetisiert werden. Dabei kann die Synthese beispielsweise auch thermisch, photochemisch, durch Mikrowellenstrahlung und/oder im Autoklaven aktiviert werden.

Zur Darstellung homoleptischer Iridium-Komplexe setzt man den Liganden bevorzugt mit Na[IrCl₂(acac)₂] bzw. Ir(acac)₃ in der Schmelze oder in einem inerten Lösungsmittel, wie z. B. Polyalkoholen (Ethylenglykol, Glycerin, etc.), Polyether-alkoholen (Di-, Tri- Tetraethylenglykol) oder Polyethern (Di-, Tri-, Tetra-, Polyethylenglykoldimethylether), bei Temperaturen von 80 bis 350 °C um. Dabei wird ein Verhältnis des Liganden zur Iridiumverbindung von 1:3 bis 1:100, bevorzugt 1:4 - 1:10 verwendet.

Zur Darstellung heteroleptischer Iridium-Komplexe mit zwei Liganden L ist es bevorzugt, den Liganden L mit einem geeigneten Ir-Precursor, bevorzugt Iridium(III)chlorid-Hydrat, in Gegenwart eine protischen Lösungsmittels oder Lösungsmittelgemischs zu chloro-verbrückten dimeren Iridium-Komplexen [L₂IrCl]₂ umzusetzen, die dann mit einem oder mehreren Liganden L', gegebenenfalls unter Zusatz von Additiven wie Basen oder Salzen (WO 2007/065523), weiter umgesetzt werden. Analog kann die Darstellung heteroleptischer Iridium-Komplexe mit einem Liganden L und zwei Liganden L' erfolgen, wobei dann zunächst das chloro-verbrückte Dimer [L'₂IrCl]₂ synthetisiert wird, welches mit L umgesetzt wird.

Durch diese Verfahren lassen sich die erfindungsgemäßen Verbindungen gemäß Formel (1) in hoher Reinheit, bevorzugt mehr als 99 % (bestimmt mittels ¹H-NMR und/oder HPLC), erhalten.

Mit den hier erläuterten Synthesemethoden lassen sich unter anderem die im Folgenden dargestellten erfindungsgemäßen Strukturen 1 bis 102 herstellen.

| | | |
|---|---|---|
| 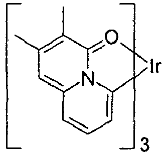 | 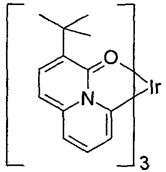 | 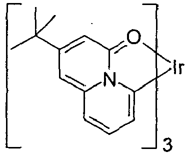 |
| 1 | 2 | 3 |
| 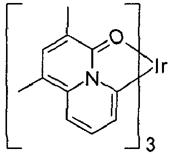 | 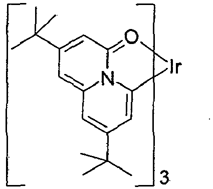 | 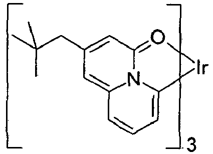 |
| 4 | 5 | 6 |
| 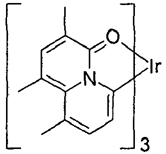 | 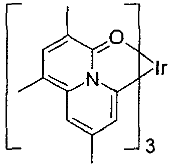 | 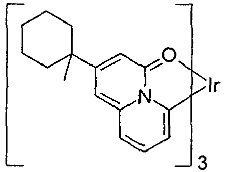 |
| 7 | 8 | 9 |
| 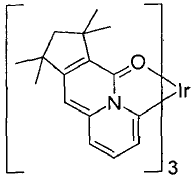 | 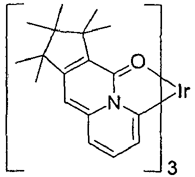 | 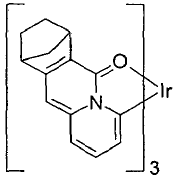 |
| 10 | 11 | 12 |
| 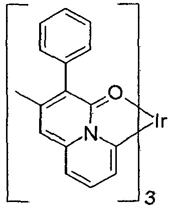 | 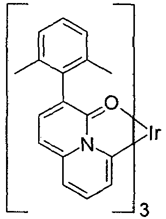 | 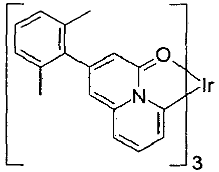 |
| 13 | 14 | 15 |
| 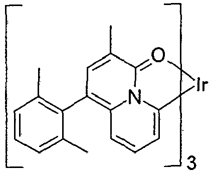 | 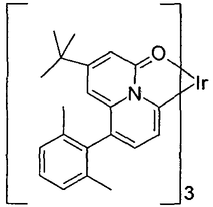 | 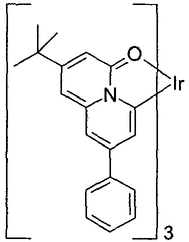 |
| 16 | 17 | 18 |
| 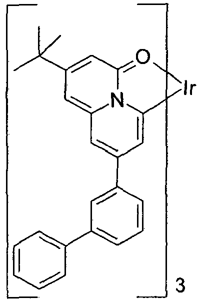 | 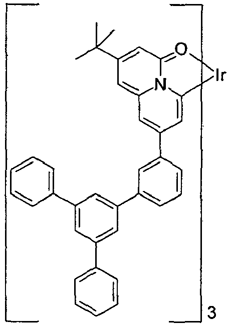 | 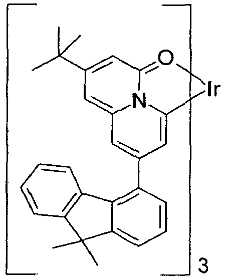 |
| 19 | 20 | 21 |
| 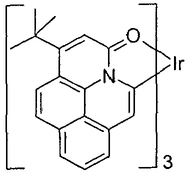 | 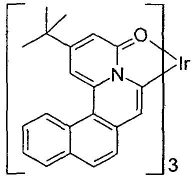 | 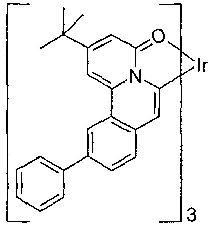 |
| 22 | 23 | 24 |
| 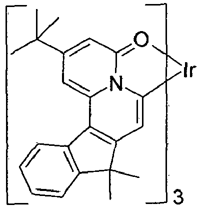 | 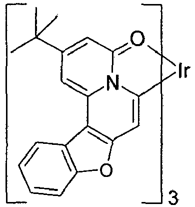 | 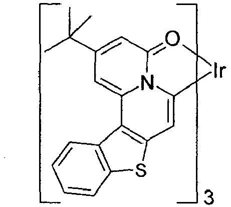 |
| 25 | 26 | 27 |
| 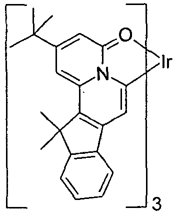 | 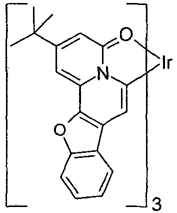 | 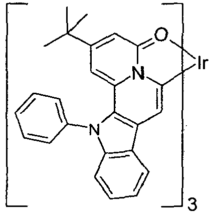 |
| 28 | 29 | 30 |
| 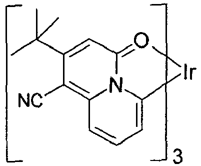 | 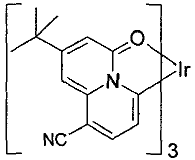 | 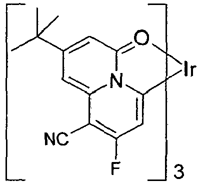 |
| 31 | 32 | 33 |
| 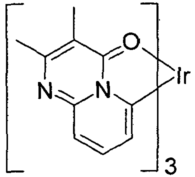 | 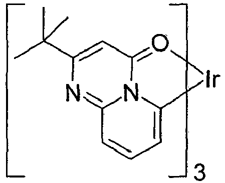 | 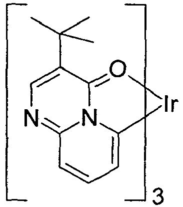 |
| 34 | 35 | 36 |
| 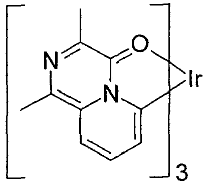 | 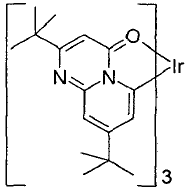 | 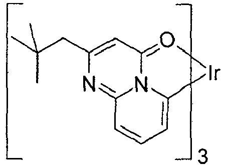 |
| 37 | 38 | 39 |
| 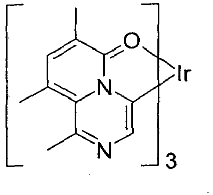 | 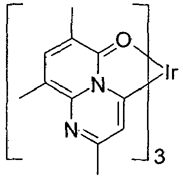 | 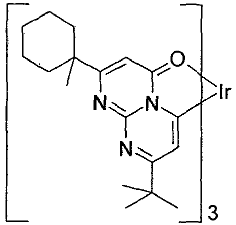 |
| 40 | 41 | 42 |
| 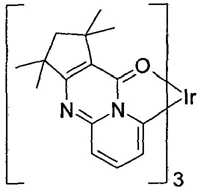 | 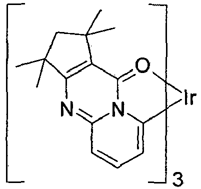 | 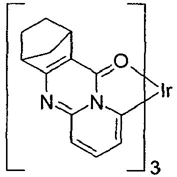 |
| 43 | 44 | 45 |
| 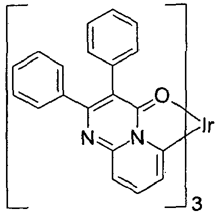 | 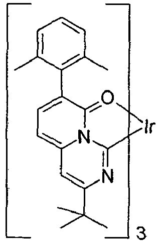 | 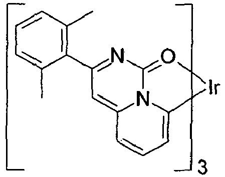 |
| 46 | 47 | 48 |
| 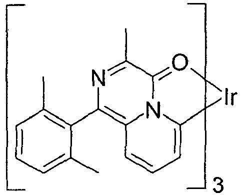 | 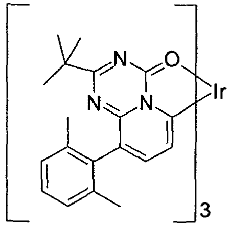 | 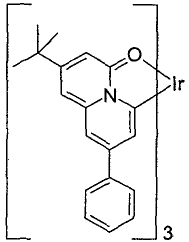 |
| 49 | 50 | 51 |
| 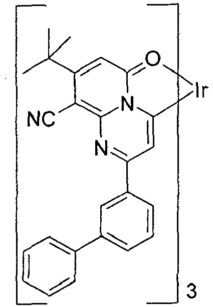 | 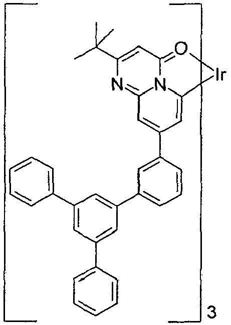 | 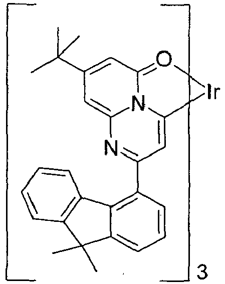 |
| 52 | 53 | 54 |
| 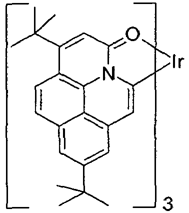 | 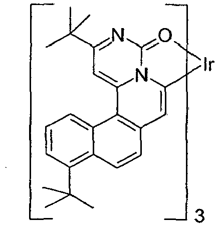 | 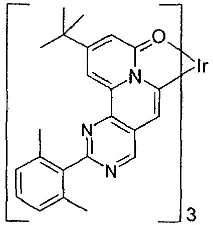 |
| 55 | 56 | 57 |
| 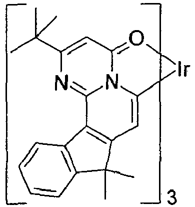 | 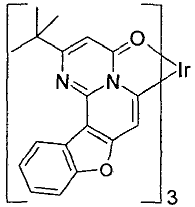 | 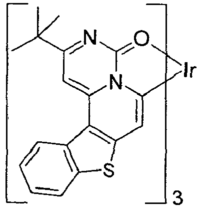 |
| 58 | 59 | 60 |
| 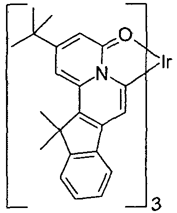 | 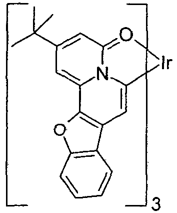 | 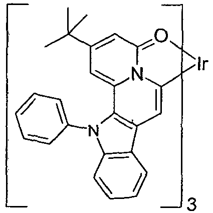 |
| 61 | 62 | 63 |
| 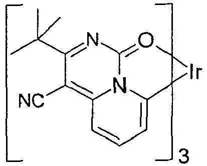 | 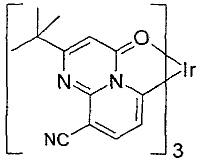 | 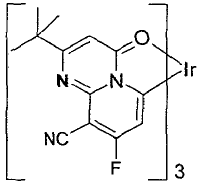 |
| 64 | 65 | 66 |
| 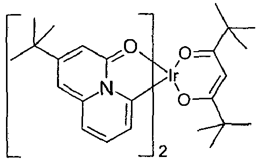 | 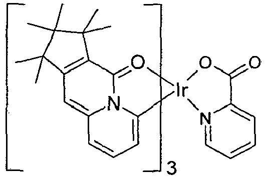 | 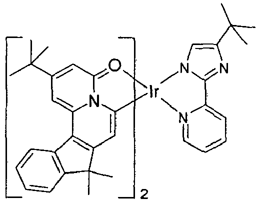 |
| 67 | 68 | 69 |
| 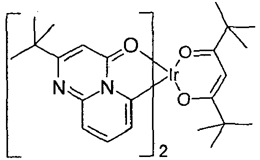 | 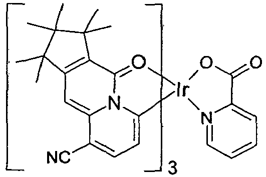 | 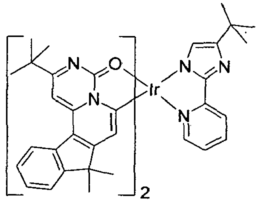 |
| 70 | 71 | 72 |
| 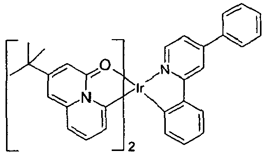 | 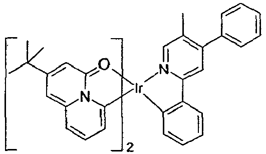 | 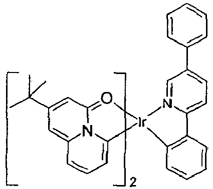 |
| 73 | 74 | 75 |
| 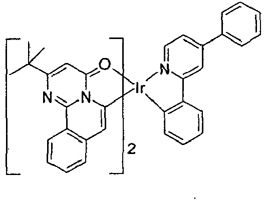 | 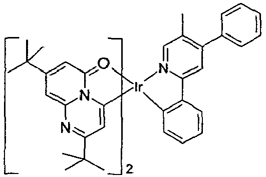 | 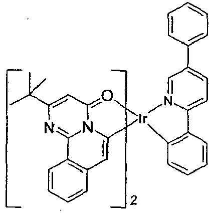 |
| 76 | 77 | 78 |
| 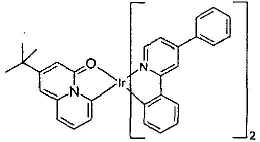 | 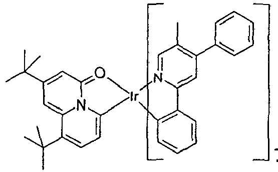 | 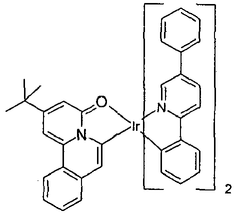 |
| 79 | 80 | 81 |
| 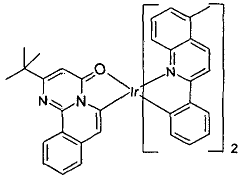 | 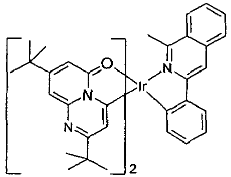 | 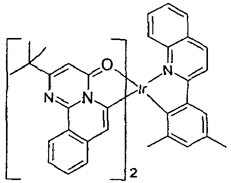 |
| 82 | 83 | 84 |
| 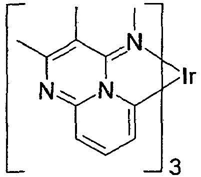 | 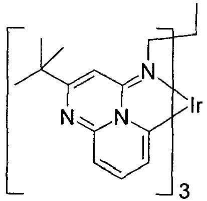 | 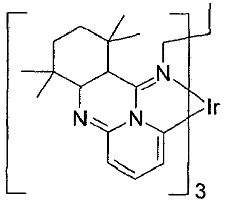 |
| 85 | 86 | 87 |
| 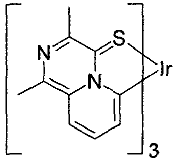 | 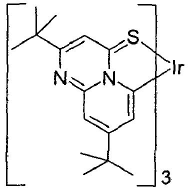 | 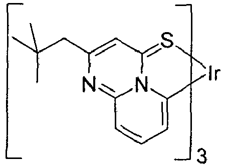 |
| 88 | 89 | 90 |
| 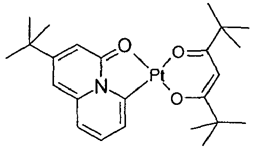 | 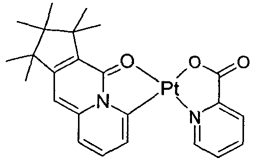 | 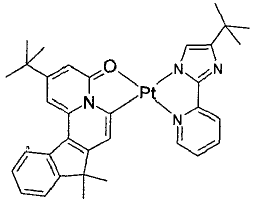 |
| 91 | 92 | 93 |
| 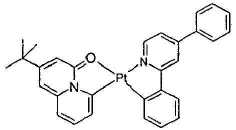 | 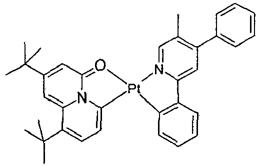 | 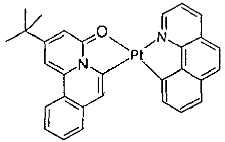 |
| 94 | 95 | 96 |
| 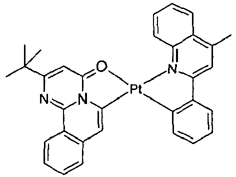 | 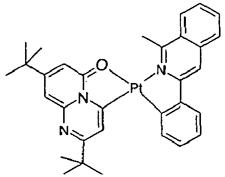 | 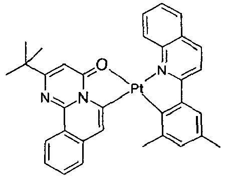 |
| 97 | 98 | 99 |
| 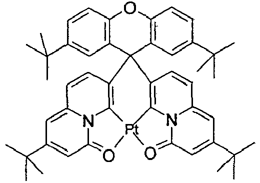 | 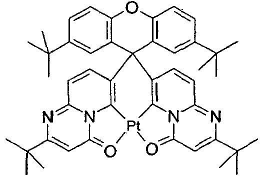 | 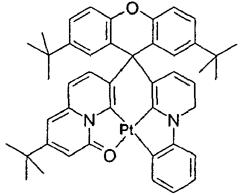 |
| 100 | 101 | 102 |

Die oben beschriebenen erfindungsgemäßen Verbindungen können auch als Wiederholeinheiten in konjugierten, teilkonjugierten oder nicht-konjugierten Oligomeren, Polymeren oder Dendrimeren Verwendung finden. Unter einem Oligomer im Sinne dieser Erfindung wird eine Verbindung mit ca. 3 bis 10 Wiederholeinheiten, die gleich oder verschieden sein können, verstanden. Die Polymerisation erfolgt dabei bevorzugt über eine Brom- oder Boronsäurefunktionalität. So können derartige Verbindungen u. a. in Polyfluorene (z. B. gemäß EP 842208 oder WO 00/22026), Poly-spirobifluorene (z. B. gemäß EP 707020 oder EP 894107), Poly-dihydrophenanthrene (z. B. gemäß WO 05/014689), Poly-indenofluorene (z. B. gemäß WO 04/041901 und WO 04/113468), Poly-phenanthrene (z. B. gemäß WO 05/104264), Poly-para-phenylene (z. B. gemäß WO 92/18552), Polycarbazole (z. B. gemäß WO 04/070772 oder WO 04/113468), Polyketone (z. B. gemäß WO 05/040302), Polysilane (z. B. gemäß WO 05/111113) oder Polythiophene (z. B. gemäß EP 1028136) einpolymerisiert werden oder auch in Copolymere, die verschiedene dieser Einheiten enthalten. Dabei können sie entweder in die Seitenkette oder in die Hauptkette des Polymers eingebaut werden oder können auch Verzweigungspunkte der Polymerketten (z. B. gemäß WO 06/003000) darstellen.

Weiterer Gegenstand der Erfindung sind somit konjugierte, teilkonjugierte oder nicht-konjugierte Oligomere, Polymere oder Dendrimere, enthaltend eine oder mehrere der Verbindungen gemäß Formel (1), wobei mindestens einer der oben definierten Reste R eine Bindung zum Polymer oder Dendrimer darstellt. Für Einheiten gemäß Formel (1) gelten in Polymeren und Dendrimeren dieselben Bevorzugungen, wie oben bereits beschrieben. Die Oligomere, Polymere oder Dendrimere können außer den oben aufgeführten Einheiten weitere Einheiten enthalten, die beispielsweise ausgewählt sind aus Wiederholeinheiten, die Lochtransporteigenschaften oder Elektronentransporteigenschaften aufweisen. Hierfür eignen sich die aus dem Stand der Technik bekannten Materialien.

Die oben genannten Oligomere, Polymere, Copolymere und Dendrimere zeichnen sich durch ihre gute Löslichkeit in organischen Lösemitteln und hohe Effizienz und Stabilität in organischen elektrolumineszierenden Vorrichtungen aus.

Weiterhin können die erfindungsgemäßen Verbindungen gemäß Formel (1), insbesondere solche, die durch Halogene funktionalisiert sind, auch durch gängige Reaktionstypen weiter funktionalisiert werden und so zu erweiterten Verbindungen gemäß Formel (1) umgesetzt werden. Hier ist als Beispiel die Funktionalisierung mit Arylboronsäuren gemäß Suzuki oder mit Aminen gemäß Hartwig-Buchwald zu nennen.

Für die Verarbeitung aus Lösung sind Lösungen bzw. Formulierungen der Verbindungen gemäß Formel (1) erforderlich. Es kann dabei bevorzugt sein, Mischungen aus zwei oder mehr Lösemitteln zu verwenden.

Ein weiterer Gegenstand der vorliegenden Erfindung ist eine Formulierung, enthaltend eine erfindungsgemäße Verbindung und mindestens eine weitere Verbindung. Die weitere Verbindung kann beispielsweise ein Lösemittel sein. Geeignete Lösemittel sind beispielsweise Toluol, o-, m- oder p-Xylol, Anisole, Methylbenzoat, Dimethylanisole, Mesitylene, Tetralin, Veratrol, Chlorbenzol, Phenoxytoluol, insbesondere 3-Phenoxytoluol, Dioxan, THF, Methyl-THf, THP oder Gemische dieser Lösemittel. Wie solche Lösungen hergestellt werden können, ist dem Fachmann bekannt und beispielsweise in der WO 2002/072714, der WO 2003/019694 und der darin zitierten Literatur beschrieben. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die oben beschriebenen Verbindungen gemäß Formel (1) bzw. die oben aufgeführten bevorzugten Ausführungsformen können in einer elektronischen Vorrichtung als aktive Komponente verwendet werden. Ein weiterer Gegenstand der vorliegenden Erfindung ist daher die Verwendung einer Verbindung nach Formel (1) bzw. nach einer der bevorzugten Ausführungsformen in einer elektronischen Vorrichtung. Weiterhin können die erfindungsgemäßen Verbindungen zur Erzeugung von Singulett-Sauerstoff, in der Photokatalyse oder in Sauerstoffsensoren eingesetzt werden.

Nochmals ein weiterer Gegenstand der vorliegenden Erfindung ist eine elektronische Vorrichtung enthaltend mindestens eine Verbindung gemäß Formel (1) bzw. nach einer der bevorzugten Ausführungsformen.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Eine bevorzugte Ausführungsform sind Dreischichtsysteme, wobei die drei Schichten blaue, grüne und orange oder rote Emission zeigen (siehe z. B. WO 2005/011013) bzw. Systeme, welche mehr als drei emittierende Schichten aufweisen. Eine weitere bevorzugte Ausführungsform sind Zweischichtsysteme, wobei die beiden Schichten entweder blaue und gelbe oder blaugrüne und orange Emission zeigen. Zweischichtsysteme sind insbesondere für Beleuchtungsanwendungen von Interesse. Solche Ausführungsformen sind mit den erfindungsgemäßen Verbindungen besonders geeignet, da diese häufig gelbe bzw. orange Emission zeigen. Die weiß emittierenden Elektrolumineszenzvorrichtungen können für Beleuchtungsanwendungen oder als Backlight für Displays oder mit Farbfilter als Display eingesetzt werden.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bzw. der Matrixmaterialien bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen. Hierfür eignen sich insbesondere Mischungen aus mindestens einem elektronentransportierenden Matrixmaterial und mindestens einem lochtransportierenden Matrixmaterial oder Mischungen aus mindestens zwei elektronentransportierenden Matrixmaterialien oder Mischungen aus mindestens einem loch- oder elektronentransportierenden Matrixmaterial und mindestens einem weiteren Material mit einer großen Bandlücke, welches somit weitgehend elektrisch inert ist und nicht oder nicht in wesentlichem Umfang am Ladungstransport teilnimmt, wie z. B. in WO 2010/108579 beschrieben. Eine bevorzugte Kombination ist beispielsweise die Verwendung eines aromatischen Ketons oder eines Triazinderivats mit einem Triarylamin-Derivat oder einem Carbazol-Derivat als gemischte Matrix für den erfindungsgemäßen Metallkomplex.

Weiterhin bevorzugt ist es, eine Mischung aus zwei oder mehr TriplettEmittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise blau oder grün emittierende Triplettemitter als Co-Matrix für die erfindungsgemäßen Komplexe gemäß Formel (1) eingesetzt werden.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

In den weiteren Schichten können generell alle Materialien verwendet werden, wie sie gemäß dem Stand der Technik für die Schichten verwendet werden und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Organische Elektrolumineszenzvorrichtungen enthaltend Verbindungen gemäß Formel (1) als emittierende Materialien weisen eine gute Lebensdauer auf.
2. Organische Elektrolumineszenzvorrichtungen enthaltend Verbindungen gemäß Formel (1) als emittierende Materialien weisen eine gute Effizienz auf.
3. Die erfindungsgemäßen Metallkomplexe sowie die dafür benötigten Liganden sind synthetisch einfach und in hohen Ausbeuten zugänglich.
4. Die erfindungsgemäßen Metallkomplexe, insbesondere solche, welche keine Gruppe der Formel (3) oder (4) enthalten, weisen verglichen mit den üblicherweise in OLEDs verwendeten Triplettemittern ein geringeres Molekulargewicht auf, was sich in einer geringeren Sublimationstemperatur wiederspiegelt.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße Verbindungen synthetisieren und diese in elektronischen Vorrichtungen verwenden und kann somit die Erfindung im gesamten offenbarten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z.B. von Sigma-ALDRICH bzw. ABCR bezogen werden. Die Nummern bei den literaturbekannten Verbindungen, die teilweise auch in eckigen Klammern angegeben sind, sind die CAS-Nummern der Verbindungen.

### A: Synthese der Liganden L:

Die Synthese der folgenden Liganden ist in der Literatur beschrieben:

| Ligand | Struktur | Literatur |
|---|---|---|
| L1 | 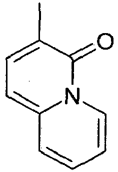 | I. Hachiya et al., Heterocycles 67, 2, 523, 2006 |
| | 880384-66-7 | |
| L2 | 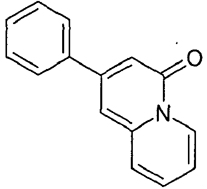 | W. Eberbach et al., Tetrahedron Letters, 30(41), 5591, 1989 |
| | 41969-31-7 | |
| L3 | 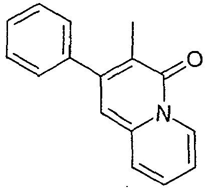 | V. Farina et al., Organic Reactions (Hoboken, NJ, United States), 50, 1997 |
| | 159219-11-1 | |
| L4 | 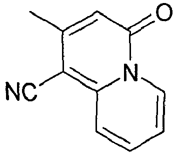 | Yu. M. Volovenko et al., Chemistry of Heterocyclic Compounds (New York, NY, United States)(Translation of Khimiya Geterotsiklicheskikh Soedinenii), 39(4), 545-546, 2003 |
| | 675820-40-3 | |
| L5 | 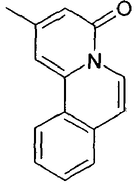 | H. Yamananka et al., Chemical & Pharmaceutical Bulletin, 29(4), 1049,1981 |
| | 58245-89-9 | |
| L6 | 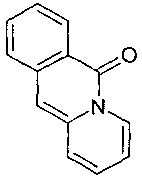 | J. DeHouwer et al., Angewandte Chemie, International Edition, 51(11), 2745, 2012 |
| | 7547-92-4 | |
| L7 | 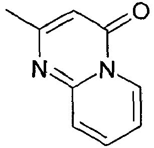 | D. Kim. Et al., Archives of Pharmacat Research, 28(9), 1019,2005 |
| | 1693-94-3 | |
| L8 | 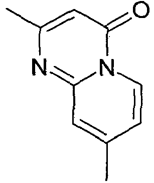 | P. L. Ferrarini et al., Journal of Heterocyclic Chemistry, 20(4), 1053, 1983 |
| | 30247-64-4 | |
| L9 | 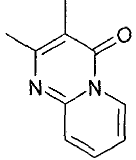 | T. H. Brown et al., Journal of the Chemical Society [Section] C: Organic, (11), 2163, 1971 |
| | 16867-29-1 | |
| L10 | 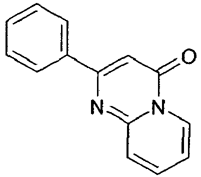 | L.-J. Pemg et al., Journal of Medicinal Chemistry, 54(21), 7729, 2011 |
| | 16054-93-6 | |
| L11 | 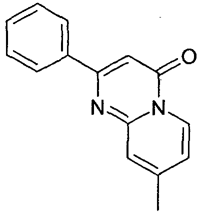 | L.-J. Pemg et al., Journal of Medicinal Chemistry, 54(21), 7729, 2011 |
| | 87591-85-3 | |
| L12 | 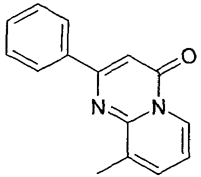 | K. Ding et al., WO2010006496 |
| | 56671-32-0 | |
| L13 | 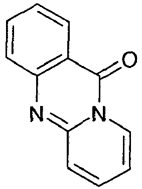 | Maity et al., Tetrahedron Letters, 52(23), 3033, 2011 |
| | 878-96-1 | |
| L14 | 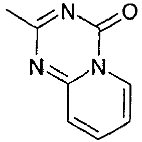 | T. Kato et al., Chemical & Pharmaceutical Bulletin, 23(10), 2251, 1975 |
| | 57859-90-2 | |
| L15 | 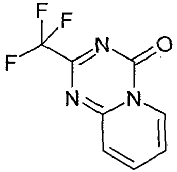 | Kiselyov et al., Tetrahedron Letters, 35(2), 207, 1994 |
| | 154160-14-2 | |

### Beispiel L16: 2-tert-Butyl-chinolizin-4-on, L16

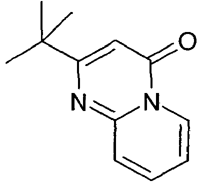

Ein Gemisch aus 9.4 g (100 mmol) 2-Aminopyridin [504-29-0], 19.0 g (120 mmol) 3-Oxo-4,4-dimethylpentansäuremethylester [55107-14-7], 960 mg (5 mmol) p-Toluolsulfonsäure Monohydrat und 200 ml o-Xylol wird 18 h am Wasserabscheider unter Rückfluss erhitzt. Dann destilliert man das o-Xylol am Wasserabscheider ab, erhöht die Temperatur auf 160 °C und rührt 2 h bei dieser Temperatur nach, um letzte Reste an Destillat abzunehmen, lässt dann auf 50 °C erkalten, fügt 30 ml Cyclohexan zu, lässt auf Raumtemperatur erkalten, saugt den auskristallisierten Feststoff ab, wäscht diesen zweimal mit wenig Cyclohexan und trocknet im Vakuum. Die Reinigung erfolgt durch zweimalige Umkristallisation aus Cyclohexan und anschließende fraktionierte Sublimation (p ca. 10⁻⁵ mbar, T = 160 °C). Ausbeute: 9.7 g (48 mmol), 48 %. Reinheit: > 99.5 % n. ¹H-NMR.

Analog können folgende Liganden L dargestellt werden:

| Bsp. | Amin | β-Ketocarbonsäureester | Ligand | Ausbeute |
|---|---|---|---|---|
| L17 | 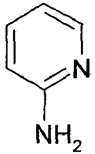 | 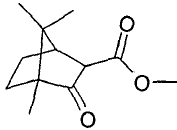 | 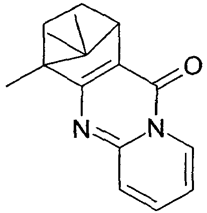 | 44 % |
| | | 135682-92-7 | | |
| L18 | 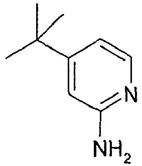 | 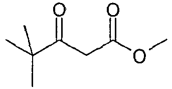 | 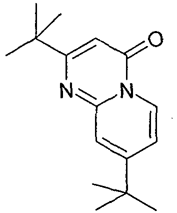 | 50 % |
| | | 55107-14-7 | | |
| L19 | 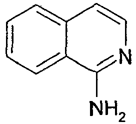 | 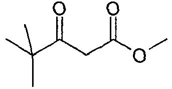 | 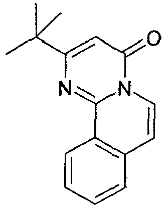 | 51 % |
| | 1532-84-9 | 55107-14-7 | | |
| L20 | 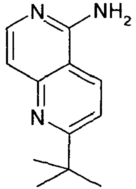 | 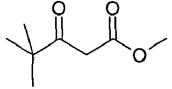 | 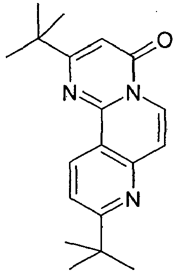 | 46 % |
| | 1352329-32-8 | 55107-14-7 | | |
| L21 | 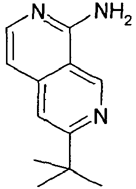 | 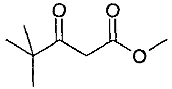 | 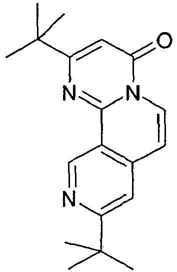 | 41 % |
| | 1352329-35-1 | 55107-14-7 | | |

### Beispiel L22: 2-tert-Butyl-chinolizin-4-on, L22

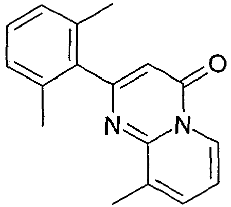

Ein Gemisch aus 19.5 g (100 mmol) 2-Chlor-9-methyl-4H-pyrido[1,2-a]-pyrimidin-4-on [17326-22-6], 19.5 g (130 mmol) 2,6-Dimethylphenylboronsäure [100379-00-8], 48.9 g (150 mmol) Caesiumcarbonat, 821 mg (2 mmol) S-Phos, 449 mg (2 mmol) Palladium(II)acetat, 200 g Glaskugeln (Durchmesser 3 mm) und 300 ml Dioxan wird 18 h unter Rückfluss erhitzt. Nach Erkalten wird über eine Celite-Schicht von den Salzen und Glaskugeln abfiltiriert, die Salze werden zweimal mit je 200 ml Dioxan nachgewaschen, das Filtrat wird zur Trockene eingeengt, der Rückstand wird in 500 ml Ethylacetat aufgenommen, die organische Phase wird dreimal mit je 300 ml Wasser, einmal mit 300 ml gesättigter Kochsalzlösung gewaschen, über Magnesiumsulfat getrocknet und im Vakuum zur Trockene eingeengt. Die Reinigung erfolgt durch zweimalige Umkristallisation aus Ethylacetat / Methanol und anschließende fraktionierte Sublimation (p ca. 10⁻⁵ mbar, T = 200 °C). Ausbeute: 15.1 g (57 mmol), 57 %. Reinheit: > 99.5 % n. ¹H-NMR.

### B: Synthese der Metallkomplexe

### 1) Homoleptische tris-faciale Iridium-Komplexe:

### Variante A: Tris-acetylacetonato-iridium(III) als Iridium-Edukt

Ein Gemisch aus 10 mmol Tris-acetylacetonato-iridium(III) [15635-87-7] und 60 mmol des Liganden L, gegebenenfalls 1-10 g, typischerweise 3 g, eines inerten hochsiedenden Zusatzes als Schmelzhilfe bzw. Lösungsmittel, z. B. Hexadecan, m-Terphenyl, Triphenylen, Diphenylether, 3-Phenoxytoluol, 1,2-, 1,3-, 1,4-Diphenoxybenzol, Triphenylphosphinoxid, Sulfolan, 18-Krone-6, Triethylenglykol, Glycerin, Polyethylenglykole, Phenol, 1-Naphthol, Hydrochinon, etc., und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol; halogenierte aliphatische Kohlenwasserstoffe sind in der Regel ungeeignet, da sie die Komplexe gegebenenfalls halogenieren oder zersetzen) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metall-Komplexes mittels NMR und / oder HPLC bestimmt. Liegt die Reinheit unter 99.5 % wird der Heißextraktionsschritt wiederholt, wobei ab der 2. Extraktion das Alox-Bett weggelassen wird. Ist eine Reinheit von 99.5 - 99.9 % erreicht, wird der Metallkomplex getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

### Variante B: Tris-(2,2,6,6-tetramethyl-3,5-heptandionato)iridium(III) als Iridium-Edukt

Durchführung analog zu Variante A, wobei anstelle von 10 mmol Tris-acetylacetonato-iridium(III) 10 mmol Tris-(2,2,6,6-tetramethyl-3,5-heptan-dionato)iridium [99581-86-9] eingesetzt werden. Die Verwendung dieses Edukts ist vorteilhaft, da die Reinheit der erhaltenen Rohprodukte häufig besser ist als bei Variante A. Außerdem ist der Druckaufbau in der Ampulle häufig nicht so ausgeprägt.

| **Bsp.** | **Ligand L** | **fac-Ir-Komplex Diastereomer** | **Variante Reaktionstemp./ Reaktionszeit Suspensionsmittel Extraktionsmittel** | **Ausbeute** |
|---|---|---|---|---|
| Ir(L1)₃ | L1 | 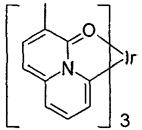 | A 260 °C / 40 h Ethylacetat o-Xylol | 38 % |
| | | Ir(L1)₃ | | |
| Ir(L2)₃ | L2 | Ir(L2)₃ | B 280 °C / 40 h Aceton o-Xylol | 46 % |
| Ir(L3)₃ | L3 | Ir(L3)₃ | wie Ir(L2)₃ | 43 % |
| Ir(L4)₃ | L4 | Ir(L4)₃ | wie Ir(L2)₃ | 28 % |
| Ir(L5)₃ | L5 | Ir(L5)₃ | wie Ir(L2)₃ | 48 % |
| Ir(L6)₃ | L6 | Ir(L6)₃ | wie Ir(L2)₃ | 45 % |
| Ir(L7)₃ | L7 | 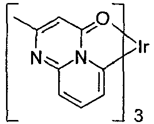 | B 280 °C / 48 h Ethylacetat o-Xylol | 50 % |
| | | Ir(L7)₃ | | |
| Ir(L8)₃ | L8 | Ir(L8)₃ | wie Ir(L7)₃ | 49 % |
| Ir(L9)₃ | L9 | Ir(L9)₃ | wie Ir(L7)₃ | 43 % |
| Ir(L10)₃ | L10 | Ir(L10)₃ | wie Ir(L7)₃ | 38 % |
| Ir(L11)₃ | L11 | Ir(L11)₃ | wie Ir(L7)₃ | 51 % |
| Ir(L12)₃ | L12 | Ir(L12)₃ | wie Ir(L7)₃ | 47 % |
| Ir(L13)₃ | L13 | Ir(L13)₃ | B 280 °C / 60 h Ethylacetat o-Xylol | 56 % |
| Ir(L14)₃ | L14 | 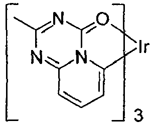 | B 290 °C / 48 h Ethylacetat Mesitylen | 23 % |
| | | Ir(L14)₃ | | |
| Ir(L15)₃ | L15 | Ir(L15)₃ | wie Ir(L14)₃ | 20 % |
| Ir(L16)₃ | L16 | Ir(L16)₃ | wie Ir(L2)₃ | 45 % |
| Ir(L17)₃ | L17 | 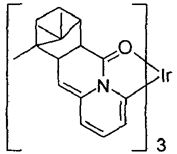 | wie Ir(L2)₃ | 51 % |
| | | Λ,Δ-Ir(L17)₃ | | |
| Ir(L18)₃ | L18 | Ir(L18)₃ | wie Ir(L2)₃ | 45 % |
| Ir(L19)₃ | L19 | Ir(L19)₃ | wie Ir(L2)₃ | 45 % |
| Ir(L20)₃ | L20 | Ir(L20)₃ | wie Ir(L14)₃ | 47 % |
| Ir(L21)₃ | L21 | Ir(L21)₃ | wie Ir(L14)₃ | 39 % |
| Ir(L22)₃ | L22 | Ir(L22)₃ | wie Ir(L2)₃ | 49 % |

### 2) Komplexe der Formel [Ir(L)₂Cl]₂:

Ein Gemisch aus 10 mmol Natrium-bisacetylacetonato-dichloro-iridat(III) [770720-50-8], 22 mmol des Liganden L und ein glasummantelter Magnetrührkern werden in ein zylindrisches Reaktionsgefäß (40 ml Volumen) mit Schraubdeckel und Teflonseptum unter Inertgas (Stickstoff oder Argon) abgefüllt. Die Reaktionsmischung wird langsam unter Rühren erhitzt, bis sich eine Schmelze bildet. Dann wird die Temperatur langsam in 20 °C Schritten alle 20 min. gesteigert, bis die Endtemperatur (s.u.) erreicht ist, wobei das sich bildende Acetylaceton über eine Kanüle im Septum abgelassen wird. Ist die Endtemperatur erreicht, wird die Reaktionsmischung weitere 20 h bei der Endtemperatur gehalten. Nach Erkalten unter Schutzgas wird der Sinterkuchen mechanisch zerkleinert, mit 100 g Glaskugeln (3 mm Durchmessser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist; typische Suspensionsmittel sind Diethylether, tert-Butyl-methylether, Ethylacetat, Dichlormethan, Aceton, Ethylacetat, Toluol, etc.) 3 h gerührt und dabei mechanisch aufgeschlossen. Man dekantiert die feine Suspension von den Glaskugeln ab, saugt den Feststoff ([Ir(L)₂Cl]₂, das noch ca. 2 eq NaCl enthält (nachfolgend das rohe Chloro-Dimer genannt) ab und trocknet diesen im Vakuum. Das so erhaltene rohe Chloro-Dimer wird im Folgenden ohne weitere Reinigung eingesetzt.

Analog können die folgenden Iridiumkomplexe dargestellt werden:

| **Bsp.** | **Ligand L** | **Ir-Komplex** | **Endtemp. Suspensionsmittel** | **Ausbeute** |
|---|---|---|---|---|
| [Ir(L1)₂Cl]₂ | L1 | 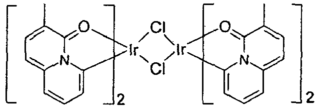 | 260 °C Ethylacetat | 92 % |
| | | [Ir(L1)₂Cl]₂ | | |
| [Ir(L9)₂Cl]₂ | L9 | [Ir(L9)₂Cl]₂ | 280 °C Aceton | 95 % |
| [Ir(L12)₂Cl]₂ | L12 | [Ir(L12)₂Cl]₂ | 270 °C Ethylacetat | 93 % |
| [Ir(L16)₂Cl]₂ | L16 | [Ir(L16)₂Cl]₂ | 270 °C Ethylacetat | 93 % |
| [Ir(L17)₂Cl]₂ | L17 | [Ir(L17)₂Cl]₂ | 290 °C Ethylacetat | 90 % |
| [Ir(L19)₂Cl]₂ | L19 | [Ir(L19)₂Cl]₂ | 270 °C Ethylacetat | 92 % |
| [Ir(L22)₂Cl]₂ | L22 | [Ir(L22)₂Cl]₂ | 270 °C Ethylacetat | 94 % |

### 3) Komplexe der Formel Ir(L)₂(L') mit Liganden L' mit O-O, O-N, N-N Donoratomen

Das in 2) erhaltene rohe Chloro-Dimer der Formel [Ir(L)₂Cl]₂ wird in einem Gemisch aus 75 ml 2-Ethoxyethanol und 25 ml Wasser suspendiert und mit 13 mmol des Liganden L' und 15 mmol Natriumcarbonat versetzt. Nach 20 h Rühren unter Rückfluss und Lichtausschluss gibt man weitere 75 ml Wasser tropfenweise zu, saugt nach Erkalten vom Feststoff ab, wäscht diesen dreimal mit je 50 ml Wasser und dreimal mit je 50 ml Methanol und trocknet diesen im Vakuum. Der trockene Feststoff wird in einem kontinuierlichen Heißextraktor auf einem 3-5 cm hohen Celite-Bett platziert und dann mit dem angegebenen Extraktionsmittel (Vorlagemenge ca. 300 ml; das Extraktionsmittel wird so gewählt, dass der Komplex darin in der Hitze gut und in der Kälte schlecht löslich ist; besonders geeignete Extraktionsmittel sind Kohlenwasserstoffe wie Toluol, Xylole, Mesitylen, Naphthalin, o-Dichlorbenzol, Aceton, Ethylacetat (EE), Dichlormethan (DCM), etc.) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Einengen des Eluats auf 50 ml und Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und / oder HPLC bestimmt. Liegt die Reinheit unter 99.5 % wird der Heißextraktionsschritt wiederholt. Ist eine Reinheit von 99.5 - 99.9 % erreicht, wird der Metallkomplex getempert oder sublimiert. Neben dem Heißextraktionsverfahren zur Reinigung kann die Reinigung auch chromatographisch an Kieselgel oder Alox mit geeigneten Elutionsmitteln (s.u.) erfolgen. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 250 - 400 °C, wobei die Sublimation bevorzugt in Form einer fraktionierten Sublimation durchgeführt wird.

| **Bsp.** | [Ir(L)₂Cl]₂ | **Co-Ligand L'** | **Ir(L)₂(L') Reinigungsmethode Extraktionsmittel Elutionsmittel** | **Ausbeute** |
|---|---|---|---|---|
| Ir(L1)₂(L'1) | [Ir(L1)₂Cl]₂ | 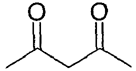 | 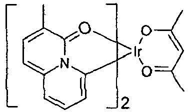 | 55 % |
| | | 123-54-6 L'1 | Chromatographie Kieselgel / DCM | |
| Ir(L16)₂(L'1) | [Ir(L16)₂Cl]₂ | L'1 | 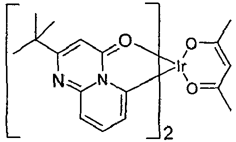 | 50% |
| | | | Chromatographie Kieselgel / DCM | |
| Ir(L17)₂(L'2) | [Ir(L17)₂Cl]₂ | 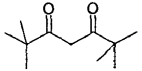 | 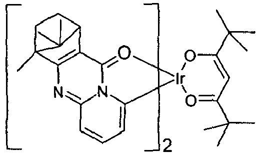 | 49 % |
| | | 1118-71-4 L'2 | | |
| | | | Chromatographie Kieselgel / EE | |
| Ir(L22)₂(L'3) | [Ir(L22)₂Cl]₂ | 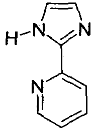 | 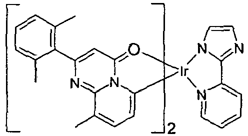 | 39 % |
| | | 18653-75-3 L'3 | Extraktion Toluol | |

### 4) Heteroleptische tris-orthometallierte Komplexe der Formel Ir(L)₂(L') und der Formel Ir(L)(L')₂ aus [Ir(L)₂Cl]₂

Die oben genannten Verbindungen werden durch Umsetzung der rohen Chloro-Dimere der Formel [Ir(L)₂Cl]₂ mit den Liganden L' in dipolar-protischen Lösungsmitteln (Ethylenglykol, Propylenglykol, Glycerin, Diethylenglykol, Triethylenglykol, etc.) erhalten. Üblicherweise fallen Gemische enthaltend beide Komplextypen der Formel Ir(L)₂(L') und der Formel Ir(L)(L')₂ an, die chromatographisch getrennt werden können. Die relativen Mengen an den Komplextypen der Formel Ir(L)₂(L') und der Formel Ir(L)(L')₂ können durch das stöchiometrische Verhältnis von [Ir(L)₂Cl]₂ zu Co-Ligand L' gesteuert werden. So entsteht bei einem stöchiometrischen Verhältnis von [Ir(L)₂Cl]₂ zu L' von 1:2 bis ca. 1:4 mehrheitlich das Produkt der Formel Ir(L)₂(L'), dagegen bei einem stöchiometrischen Verhältnis von [Ir(L)₂Cl]₂ zu L' von ca. 1:6 bis ca. 1:12 mehrheitlich das Produkt der Formel Ir(L)(L')₂.

Das in 2) erhaltene rohe Chloro-Dimer der Formel [Ir(L)₂Cl]₂ wird in 100 ml des angegebenen Lösungsmittels vorgelegt. Die Reaktionsmischung wird durch Durchleiten eines Inertgasstroms (Stickstoff oder Argon) unter Rühren entgast. Dann fügt man die angegebene Menge an Ligand L' zu und rührt das Gemisch unter Lichtausschluss 48 h bei 160 °C. Nach Abkühlen auf 70 °C tropft man 100 ml Ethanol zu, lässt unter Rühren erkalten, saugt vom ausgefallenen Feststoff ab, wäscht diesen dreimal mit je 30 ml Ethanol und trocknet im Vakuum. Die Komplexe der Formel Ir(L)₂(L') und der Formel Ir(L)(L')₂ werden chromatographisch isoliert, wobei der Verlauf auf DC-Karten verfolgt wird. Saubere Fraktionen werden vereinigt und fast bis zur Trockene eingeengt, wobei das Produkt häufig auskristallisiert. Man fügt dann Ethanol zu, bringt mit Ethanol auf eine Schutzgasfritte, wäscht mehrmals mit wenig Ethanol und trocknet im Vakuum. Gegebenenfalls wird erneut chromatographiert, bis eine Reinheit > 99.5 % oder mehr erreicht ist. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 250-400 °C, wobei die Sublimation bevorzugt in Form einer fraktionierten Sublimation durchgeführt wird.

| **Bsp.** | **[Ir(L)₂Cl]₂** | **Co-Ligand L'** | **Ir(L)₂(L') Ir(L)(L')₂ Stöchiometrie Lösungsmittel [Ir(L)₂Cl]₂: L' Adsorbens / Elutionsmittel** | **Ausbeute** |
|---|---|---|---|---|
| Ir(L1)₂(L'4) | [Ir(L1)₂Cl]₂ | 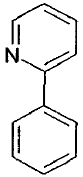 | 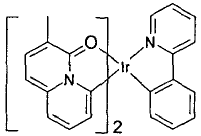 | 36 % |
| Ir(L1)(L'4)₂ | | L'4 1008-89-5 | 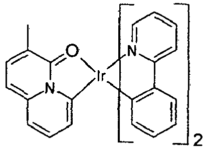 | 13 % |
| | | | 1:4 Ethylenglykol Kieselgel / DCM | |
| Ir(L1)₂(L'4) | [Ir(L1)₂Cl]₂ | L'4 | 1:12 | 16% |
| Ir(L1)(L'4)₂ | | | Propylenglykol Kieselgel / DCM | 39 % |
| Ir(L12)₂(L'5) | [Ir(L12)₂Cl]₂ | 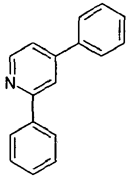 | 1:4 Ethylenglykol Kieselgel / DCM | 36 % |
| Ir(L12)(L'5)₂ | | | | 14 % |
| | | L'5 26274-35-1 | | |
| Ir(L16)₂(L'6) | [Ir(L16)₂Cl]₂ | 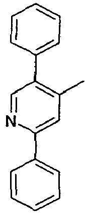 | 1:6 Ethylenglykol Kieselgel / EE | 18% |
| Ir(L16)(L'6)₂ | | | | 33% |
| | | L'6 156021-08-8 | | |
| Ir(L17)₂(L'7) | [Ir(L17)₂Cl]₂ | 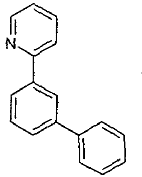 | 1:6 Ethylenglykol Kieselgel / DCM | 16 % |
| Ir(L17)(L'7)₂ | | | | 35 % |
| | | L'7 458541-39-4 | | |
| Ir(L19)₂(L'8) | [Ir(L19)₂Cl]₂ | 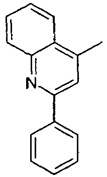 | 1:6 Ethylenglykol Kieselgel / DCM | 16% |
| Ir(L19)(L'8)₂ | | | | 32 % |
| | | L'8 4789-76-8 | | |
| Ir(L22)₂(L'9) | [Ir(L15)₂Cl]₂ | 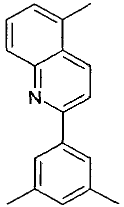 | 1:8 Ethylenglykol / 175 °C Kieselgel / DCM | 15 % |
| Ir(L22)(L'9)₂ | | | | 31 % |
| | | L'9 1056451-61-6 | | |

### Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (Indium Zinn Oxid) bilden die Substrate, auf weiche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:M2:Ir-Komplex (55%:35%:10%) bedeutet hierbei, dass das Material M1 in einem Volumenanteil von 55%, M2 in einem Anteil von 35% und Ir-Komplex in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (JUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Die Ergebnisse der OLEDs sind in Tabelle 2 zusammengefasst.

**Tabelle 1: Aufbau der OLED**

| **Bsp.** | **HTL2 Dicke** | **EBL Dicke** | **EML Dicke** | **ETL Dicke** |
|---|---|---|---|---|
| D-Ir(L1)₃ | HTM 100 nm | EBM 20 nm | M1:M2:Ir(L1)₃ (35%:60%:5%) 30 nm | ETM1:ETM2 (50%:50%) 20 nm |
| D-Ir(L2)₃ | HTM 120 nm | EBM 20 nm | M1:M2:Ir(L2)₃ (35%:60%:5%) 30 nm | ETM1:ETM2 (50%:50%) 20 nm |
| D-Ir(L3)₃ | HTM 100 nm | EBM 20 nm | M1:M2:Ir(L3)₃ (30%:60%:10%) 30 nm | ETM1:ETM2 (50%:50%) 20 nm |
| D-Ir(L4)₃ | HTM 70 nm | EBM 20 nm | M1:M2:Ir(L4)₃ (55%:40%:5%) 30 nm | ETM1:ETM2 (50%:50%) 20 nm |
| D-Ir(L5)₃ | HTM 110 nm | EBM 20 nm | M1:M2:Ir(L5)₃ (30%:70%:5%) 30 nm | ETM1:ETM2 (50%:50%) 20 nm |
| D-Ir(L6)₃ | HTM 110 nm | EBM 20 nm | M1:M2:Ir(L6)₃ (35%:60%:5%) 30 nm | ETM1:ETM2 (50%:50%) 20 nm |
| D-Ir(L7)₃ | HTM 100 nm | EBM 20 nm | M1:M2:Ir(L7)₃ (65%:30%:5%) 30 nm | ETM1:ETM2 (50%:50%) 20 nm |
| D-Ir(L8)₃ | HTM 100 nm | EBM 20 nm | M1:M2:Ir(L8)₃ (65%:30%:5%) 30 nm | ETM1:ETM2 (50%:50%) 20 nm |
| D-Ir(L9)₃ | HTM 100 nm | EBM 20 nm | M1:M2:Ir(L9)₃ (65%:30%:5%) 30 nm | ETM1:ETM2 (50%:50%) 20 nm |
| D-Ir(L10)₃ | HTM 110 nm | EBM 20 nm | M1:M2:Ir(L10)₃ (60%:30%:10%) 30 nm | ETM1:ETM2 (50%:50%) 20 nm |
| D-Ir(L11)₃ | HTM 110 nm | EBM 20 nm | M1:M2:Ir(L11)₃ (65%:30%:5%) 30 nm | ETM1:ETM2 (50%:50%) 20 nm |
| D-Ir(L12)₃ | HTM 110 nm | EBM 20 nm | M1:M2:Ir(L12)₃ (65%:30%:5%) 30 nm | ETM1:ETM2 (50%:50%) 20 nm |
| D-Ir(L13)₃ | HTM 100 nm | EBM 20 nm | M2:M2:Ir(L12)₃ (65%:30%:5%) 30 nm | ETM1:ETM2 (50%:50%) 20 nm |
| D-Ir(L14)₃ | HTM 70 nm | EBM 20 nm | M1:M2:Ir(L14)₃ (70%:25%:5%) 30 nm | ETM1.ETM2 (50%:50%) 20 nm |
| D-Ir(L15)₃ | HTM 70 nm | EBM 20 nm | M1:M2:Ir(L15)₃ (65%:30%:5%) 30 nm | ETM1:ETM2 (50%:50%) 20 nm |
| D-Ir(L16)₃ | HTM 100 nm | EBM 20 nm | M1:M2:Ir(16)₃ (65%:30%:5%) 30 nm | ETM1:ETM2 (50%:50%) 20 nm |
| D-Ir(L17)₃ | HTM 100 nm | EBM 20 nm | M1:M2:Ir(L17)₃ (65%:30%:5%) 30 nm | ETM1:ETM2 (50%:50%) 20 nm |
| D-Ir(L18)₃ | HTM 100 nm | EBM 20 nm | M1:M2:Ir(L18)₃ (65%:30%:5%) 30 nm | ETM1.ETM2 (50%:50%) 20 nm |
| D-Ir(L19)₃ | HTM 110 nm | EBM 20 nm | M1:M2:Ir(L19)₃ (65%:30%:5%) 30 nm | ETM1:ETM2 (50%:50%) 20 nm |
| D-Ir(L20)₃ | HTM 110 nm | EBM 20 nm | M1:M2:Ir(L20)₃ (65%:30%:5%) 30 nm | ETM1:ETM2 (50%:50%) 20 nm |
| D-Ir(L21)₃ | HTM 110 nm | EBM 20 nm | M1:M2:Ir(L21)₃ (65%:30%:5%) 30 nm | ETM1:ETM2 (50%:50%) 20 nm |
| D-Ir(L22)₃ | HTM 180 nm | EBM 20 nm | M1:M2:Ir(L22)₃ (65%:30%:5%) 30 nm | ETM1:ETM2 (50%:50%) 20 nm |
| D-Ir(L1)₂(L'1) | HTM 100 nm | EBM 20 nm | M1:M2: Ir(L1)₂(L'1) (65%:30%:5%) 30 nm | ETM1.ETM2 (50%:50%) 20 nm |
| D-Ir(L16)₂(L'1) | HTM 100 nm | EBM 20 nm | M1:M2: Ir(L16)₂(L'1) (65%:30%:5%) 30 nm | ETM1:ETM2 (50%:50%) 20 nm |
| D-Ir(L 17)₂(L'2) | HTM 100 nm | EBM 20 nm | M1:M2: Ir(L17)₂(L'2) (65%:30%:5%) 30 nm | ETM1:ETM2 (50%:50%) 20 nm |
| D-Ir(L22)₂(L'3) | HTM 100 nm | EBM 20 nm | M1:M2: Ir(L22)₂(L'3) (65%:30%:5%) 30 nm | ETM1:ETM2 (50%:50%) 20 nm |
| D-Ir(L1)₂(L'4) | HTM 1ß0 nm | EBM 20 nm | M1:M2: Ir(L1)₂(L'4) (65%:30%:5%) 30 nm | ETM1:ETM2 (50%:50%) 20 nm |
| D-Ir(L 1)(L'4)₂ | HTM 100 nm | EBM 20 nm | M1:M2: Ir(L1)(L'4)₂ (65%:30%:5%) 30 nm | ETM1:ETM2 (50%:50%) 20 nm |
| D-Ir(L12)(L'5)₂ | HTM 120 nm | --- | M1:M2: Ir(L12)(L'5)₂ (65%:30%:5%) 30 nm | ETM1:ETM2 (50%:50%) 20 nm |
| D-Ir(L 16)₂(L'6) | HTM 100 nm | EBM 20 nm | M1:M2: Ir(L16)₂(L'6) (65%:30%:5%) 30 nm | ETM1:ETM2 (50%:50%) 20 nm |
| D-Ir(L17)(L'7)₂ | HTM 130 nm | --- | M1:M2: Ir(L17)(L'7)₂ (65%:30%:5%) 30 nm | ETM1:ETM2 (50%:50%) 20 nm |
| D-Ir(L 19)(L'8)₂ | HTM 150 nm | --- | M1:M2: Ir(L19)(L'8)₂ (50%:45%:5%) 35 nm | ETM1.ETM2 (50%:50%) 20 nm |
| D-Ir(L22)(L'9)₂ | HTM 150 nm | --- | M1:M2: (L22)(L'9)₂ (55%:40%:5%) 35 nm | ETM1:ETM2 (50%:50%) 20 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD50 (h) 1000 cd/m²** |
|---|---|---|---|---|
| D-Ir(L1)₃ | 12.5 | 3.3 | 0.32/0.64 | 25.000 |
| D-Ir(L2)₃ | 12.9 | 3.4 | 0.40/0.58 | 33.000 |
| D-Ir(L3)₃ | 13.4 | 3.3 | 0.33/0.65 | --- |
| D-Ir(L4)₃ | 9.2 | 3.8 | 0.17/0.38 | --- |
| D-Ir(L5)₃ | 15.0 | 3.3 | 0.44/0.53 | 36.000 |
| D-Ir(L6)₃ | 0.5 | 3.6 | 0.72/0.27 | --- |
| D-Ir(L7)₃ | 16.0 | 3.2 | 0.33/0.66 | --- |
| D-Ir(L8)₃ | 16.3 | 3.3 | 0.34/0.65 | 40.000 |
| D-Ir(L9)₃ | 15.9 | 3.3 | 0.32/0.67 | 45.000 |
| D-Ir(L10)₃ | 15.5 | 3.2 | 0.40/0.58 | 48.000 |
| D-Ir(L11)₃ | 15.8 | 3.3 | 0.41/0.57 | --- |
| D-Ir(L12)₃ | 15.8 | 3.3 | 0.41/0.58 | --- |
| D-Ir(L13)₃ | 0.3 | 3.9 | --- | --- |
| D-Ir(L14)₃ | 7.9 | 3.8 | 0.27/0.69 | 6000 |
| D-Ir(L15)₃ | 8.4 | 4.4 | 0.24//0.55 | --- |
| D-Ir(L16)₃ | 17.0 | 3.3 | 0.32/0.66 | 46.000 |
| D-Ir(L17)₃ | 18.2 | 3.3 | 0.34/0.65 | 54.000 |
| D-Ir(L18)₃ | 17.8 | 3.2 | 0.35/0.64 | 50.000 |
| D-Ir(L19)₃ | 18.1 | 3.4 | 0.40/0.58 | --- |
| D-Ir(L20)₃ | 16.4 | 3.5 | 0.43/0.56 | --- |
| D-Ir(L21)₃ | 17.2 | 3.2 | 0.41/0.58 | --- |
| D-Ir(L22)₃ | 11.4 | 3.2 | 0.33/0.66 | --- |
| D-Ir(L1)₂(L'1) | 15.6 | 3.4 | 0.35/0.64 | 38.000 |
| D-Ir(L16)₂(L'1) | 15.1 | 3.5 | 0.36/0.63 | --- |
| DIr(L17)₂(L'2) | 16.4 | 3.7 | 0.38/0.61 | --- |
| D-Ir(L22)₂(L'3) | 13.7 | 3.6 | 0.29/0.69 | --- |
| D-Ir(L1)₂(L'4) | 14.6 | 3.2 | 0.32/0.67 | --- |
| DIr(L1)(L'4)₂ | 14.5 | 3.3 | 0.33/0.66 | 52.000 |
| D-Ir(L12)(L'5)₂ | 16.0 | 3.2 | 0.43/0.56 | --- |
| DIr(L16)₂(L'6) | 16.6 | 3.3 | 0.33/0.66 | 55.000 |
| D-Ir(L17)(L'7)₂ | 17.2 | 3.2 | 0.44/0.55 | 68.000 |
| D-Ir(L19)(L'8)₂ | 16.5 | 3.1 | 0.67/0.32 | 88.000 |
| D-Ir(L22)(L'9)₂ | 16.7 | 3.1 | 0.68/0.32 | 92.000 |

### 2) Lösungs-prozessierte Devices:

### A: Aus löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z.B. in der WO 2004/037887). Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf weiche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für eine Device typische Schichtdicke von 80 nm mittels Spincoating erzielt werden soll. Die lösungsprozessierten Devices enthalten eine Emissionsschicht aus (Polystyrol):M1:M2:Ir-Komplex (25%:25%:40%:10%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x 10⁻⁶ mbar) aufgedampft. Optional kann zunächst eine Lockblockierschicht und dann eine Eletronentransportschicht und dann erst die Kathode (z. B. Al oder LiF/Al) im Vakuum aufgedampft werden. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

**Tabelle 3: Ergebnisse mit aus Lösung prozessierten Materialien**

| **Bsp.** | **Ir-Komplex** | **EQE (%) 1000 cd/m²** | **Spannung (V) 1000 cd/m²** | **CIE x/y 1000 cd/m²** |
|---|---|---|---|---|
| DL-Ir(L22)₃ | Ir(L22)₃ | 10.3 % | 5.7 | 0.34/0.63 |
| DL-Ir(L17)(L'7)₂ | Ir(L17)(L'7)₂ | 15.0 % | 5.6 | 0.40/0.58 |
| DL-Ir(L22)(L'9)₂ | Ir(L22)(L'9)₂ | 16.4 % | 5,6 | 0.68/0.32 |

**Tabelle 4: Strukturformeln der verwendeten Materialien**

| | |
|---|---|
| 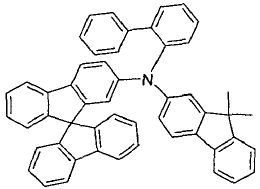 | 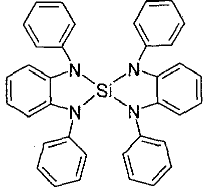 |
| HTM | EBM |
| 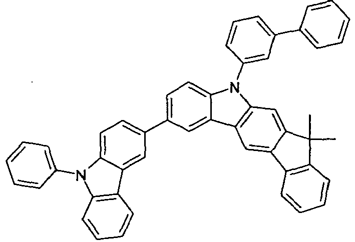 | 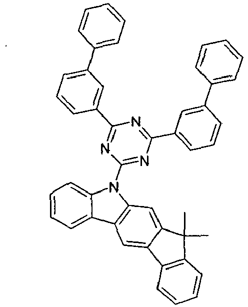 |
| M1 | M2 |
| 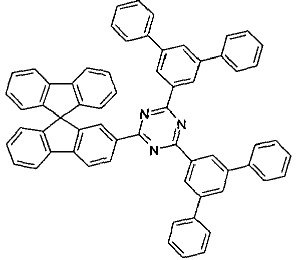 | 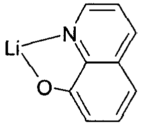 |
| ETM1 | ETM2 |

## Patentansprüche

1. Verbindung gemäß Formel (1),
M(L)ₙ(L')ₘ Formel (1)
enthaltend eine Teilstruktur M(L)ₙ der Formel (2): 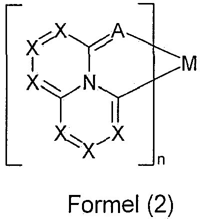 wobei für die verwendeten Symbole und Indizes gilt:
M ist ein Übergangsmetall;
A ist bei jedem Auftreten gleich oder verschieden O, S oder NR;
X ist bei jedem Auftreten gleich oder verschieden CR oder N;
oder zwei benachbarte Gruppen stehen für eine Gruppe der folgenden Formel (3) oder (4), 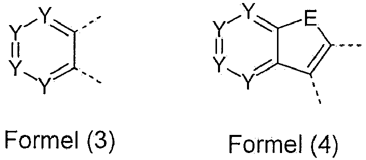 wobei die gestrichelten Bindungen die Verknüpfung dieser Gruppe im Molekül andeuten;
Y ist bei jedem Auftreten gleich oder verschieden CR oder N;
E ist bei jedem Auftreten gleich oder verschieden CR₂, NR, O oder S;
R ist bei jedem Auftreten gleich oder verschieden H, D, F, Cl, Br, I, N(R¹)₂, P(R¹)₂, CN, NO₂, Si(R¹)₃, B(OR¹)₂, C(=O)R¹, P(=O)(R¹)₂, S(=O)R¹, S(=O)₂R¹, OSO₂R¹, OH, SH, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, Ge(R¹)₂, Sn(R¹)₂, C=O, C=S, C=Se, C=NR¹, P(=O)(R¹), SO, SO₂, NR¹, O, S oder CONR¹ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches oder aromatisches Ringsystem bilden;
R² ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R² auch miteinander ein mono- oder polycyclisches, aliphatisches oder aromatisches Ringsystem bilden;
L' ist gleich oder verschieden bei jedem Auftreten ein beliebiger Coligand;
n ist 1, 2 oder 3;
m ist 0, 1, 2, 3 oder 4;
dabei können auch mehrere Liganden L miteinander oder L mit L' über eine beliebige Brücke V verknüpft sein und so ein tridentates, tetradentates, pentadentates oder hexadentates Ligandensystem aufspannen.

2. Verbindung nach Anspruch 1, **dadurch gekennzeichnet, dass** M ausgewählt ist aus der Gruppe bestehend aus Iridium, Platin, Chrom, Molybdän, Wolfram, Rhenium, Ruthenium, Osmium, Rhodium, Nickel, Palladium, Kupfer, Silber und Gold.

3. Verbindung nach Anspruch 1 oder 2, **dadurch gekennzeichnet, dass** die Teilstruktur der Formel (2) ausgewählt ist aus den Strukturen der Formeln (5) bis (17), 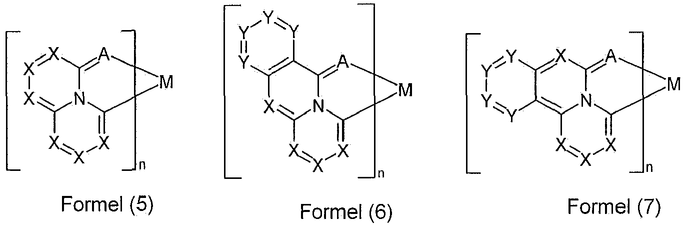 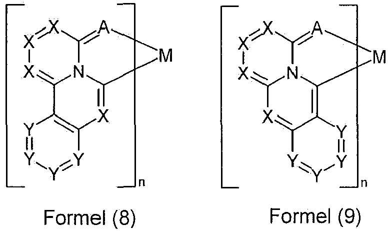 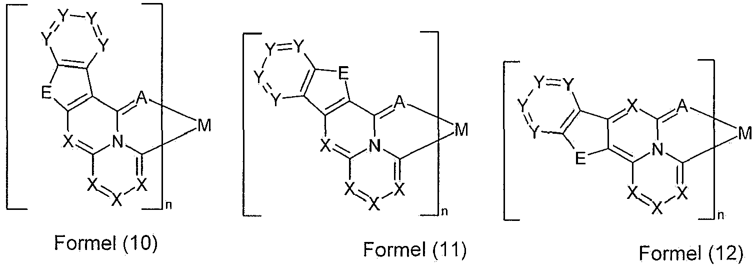 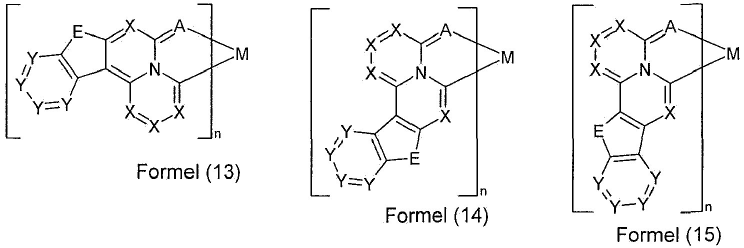 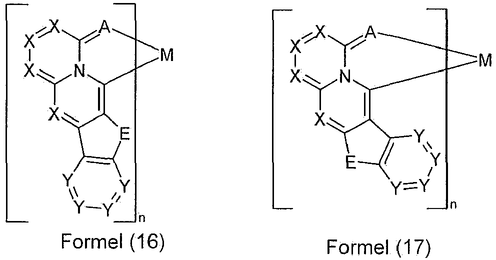 wobei X gleich oder verschieden bei jedem Auftreten für CR oder N steht und die weiteren Symbole und Indizes die in Anspruch 1 genannten Bedeutungen aufweisen.

4. Verbindung nach einem oder mehreren der Ansprüche 1 bis 3, **dadurch gekennzeichnet, dass** maximal zwei Gruppen X, bevorzugt maximal eine Gruppe X, pro Cyclus für Stickstoff stehen, und die anderen Gruppen X in dem Cyclus für CR stehen und dass maximal zwei Gruppen Y, bevorzugt maximal eine Gruppe Y pro Cyclus für Stickstoff stehen, und die weiteren Symbole Y in dem Cyclus für CR stehen.

5. Verbindung nach einem oder mehreren der Ansprüche 1 bis 4, **dadurch gekennzeichnet, dass** die Teilstruktur der Formel (2) ausgewählt ist aus den Strukturen der Formeln (5a) bis (5d), (7a) bis (7c) und (8a) bis (8c), 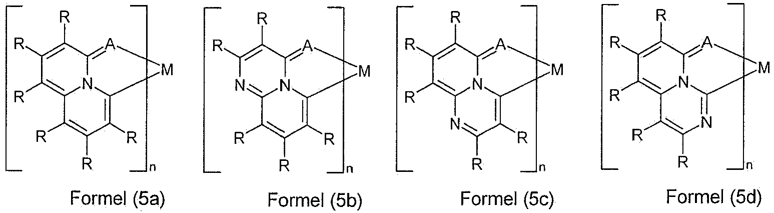 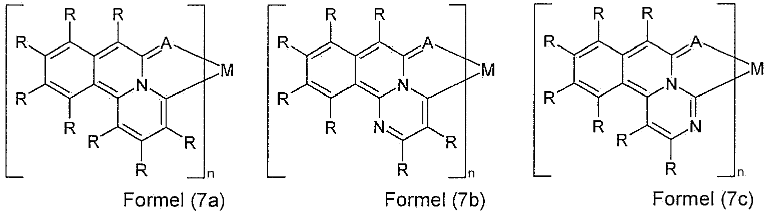 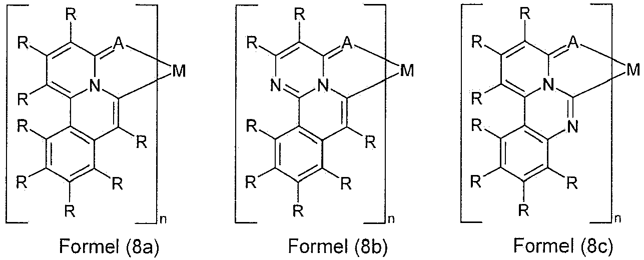 wobei die verwendeten Symbole und Indizes die in Anspruch 1 genannten Bedeutungen aufweisen.

6. Verbindung nach einem oder mehreren der Ansprüche 1 bis 5, **dadurch gekennzeichnet, dass** A für O oder S steht.

7. Verbindung nach einem oder mehreren der Ansprüche 1 bis 6, **dadurch gekennzeichnet, dass**, wenn eine oder mehrere Gruppen X für N stehen, benachbart zu diesen N-Atom mindestens ein Substituent R ungleich H oder D gebunden ist, insbesondere eine Alkylgruppe, Alkoxygruppe, substituierte Aminogruppe, Aralkylgruppe oder ein aromatisches oder heteroaromatisches Ringsystem.

8. Verbindung nach einem oder mehreren der Ansprüche 1 bis 7, **dadurch gekennzeichnet, dass** der Ligand L zwei benachbarte Kohlenstoffatome aufweist, die jeweils mit Resten R substituiert sind, wobei die jeweiligen Reste R zusammen mit den C-Atomen einen Ring der Formel (18), (19), (20) oder (20a) bis (20d) aufspannen, 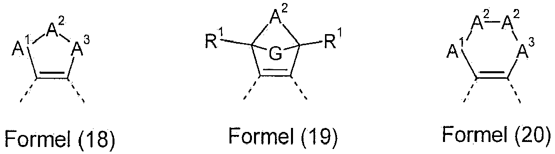 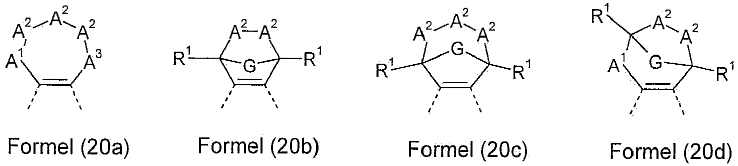 wobei R¹ und R² die oben genannten Bedeutungen aufweisen, die gestrichelten Bindungen die Verknüpfung der beiden Kohlenstoffatome im Liganden andeuten und weiterhin gilt:
A¹, A³ ist gleich oder verschieden bei jedem Auftreten C(R³)₂, O, S, NR³ oder C(=O);
A² ist gleich oder verschieden bei jedem Auftreten C(R¹)₂, O, S, NR³ oder C(=O);
oder die beiden Gruppen A² in Formel (20) zusammen stehen für eine Gruppe der folgenden Formel (21) oder (22), 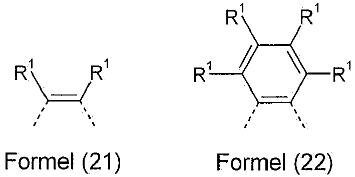
G ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
R³ ist gleich oder verschieden bei jedem Auftreten F, eine geradkettige Alkyl- oder Alkoxygruppe mit 1 bis 20 C-Atomen, eine verzweigte oder cyclische Alkyl- oder Alkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³ miteinander ein aliphatisches oder aromatisches Ringsystem bilden; weiterhin kann R³ mit einem benachbarten Rest R oder R¹ ein aliphatisches Ringsystem bilden;
mit der Maßgabe, dass in A¹-A²-A³ nicht zwei Heteroatome direkt aneinander gebunden sind.

9. Verbindung nach einem oder mehreren der Ansprüche 1 bis 8, ausgewählt aus den Strukturen der Formeln (24) bis (28), 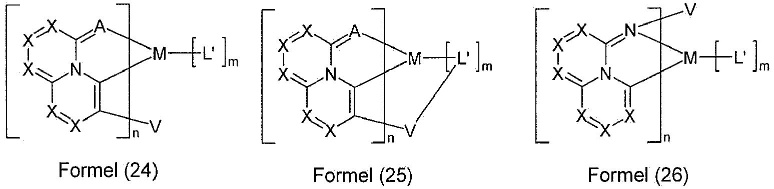 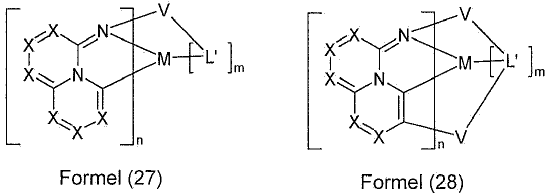 wobei die verwendeten Symbole und Indizes die in Anspruch 1 genannten Bedeutungen aufweisen und V eine verbrückende Einheit darstellt, enthaltend 1 bis 80 Atome aus der dritten, vierten, fünften und/oder sechsten Hauptgruppe oder einen 3- bis 6-gliedrigen Homo- oder Heterocyclus, die die Teilliganden L miteinander oder L mit L' miteinander kovalent verbindet.

10. Verbindung nach einem oder mehreren der Ansprüche 1 bis 9, **dadurch gekennzeichnet, dass** L' gleich oder verschieden bei jedem Auftreten ausgewählt ist aus der Gruppe bestehend aus Kohlenmonoxid, Stickstoffmonoxid, Alkylcyaniden, Arylcyaniden, Alkylisocyaniden, Arylisocyaniden, Aminen, Phosphinen, Phosphiten, Arsinen, Stibinen, stickstoffhaltigen Heterocyclen, Carbenen, Hydrid, Deuterid, den Halogeniden F⁻, Cl⁻, Br und I⁻, Alkylacetyliden, Arylacetyliden, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten, Arylgruppen, O²⁻, S²⁻, Carbiden, Nitrenen, Diaminen, Iminen, Diiminen, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten, Dithiolaten, Boraten stickstoffhaltiger Heterocyclen und Liganden, welche durch eine Kombination der Gruppen der Formeln (43) bis (65) gebildet werden, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet und der Ligand gebildet wird, indem diese Gruppen jeweils an der durch # gekennzeichneten Position aneinander binden, 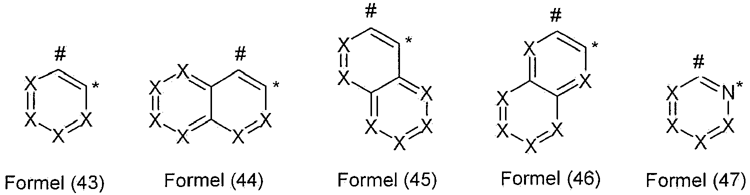 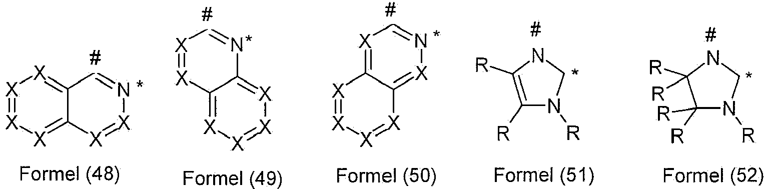 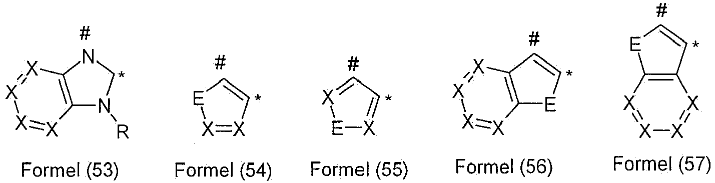 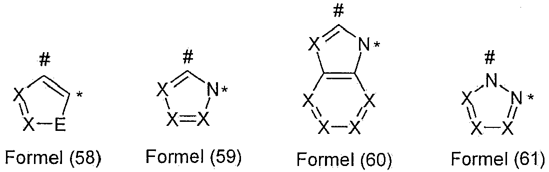 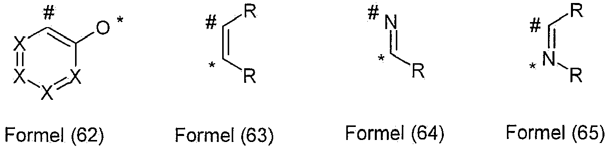 dabei haben die verwendeten Symbole die in Anspruch 1 genannten Bedeutungen, und die Position, an der die Gruppe an das Metall koordiniert, ist durch * gekennzeichnet.

11. Verfahren zur Herstellung einer Verbindung nach einem oder mehreren der Ansprüche 1 bis 10 durch Umsetzung des entsprechenden freien Liganden mit Metallalkoholaten der Formel (70), mit Metallketoketonaten der Formel (71), mit Metallhalogeniden der Formel (72), mit dimeren Metallkomplexen der Formel (73) oder mit Metallverbindungen, die sowohl Alkoholat- und/oder Halogenid- und/oder Hydroxy- wie auch Ketoketonatreste tragen,
M(OR¹)ₙ Formel (70) 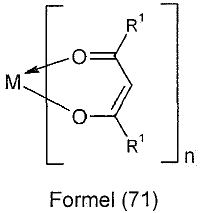
MHalₙ Formel (72) 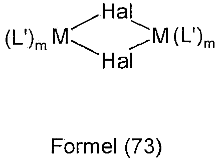
wobei die Symbole und Indizes M, L', m, n und R¹ die in Anspruch 1 angegebenen Bedeutungen haben und Hal = F, Cl, Br oder I ist.

12. Oligomer, Polymer oder Dendrimer, enthaltend eine oder mehrere der Verbindungen nach einem oder mehreren der Ansprüche 1 bis 10, wobei mindestens einer der Reste R eine Bindung zum Oligomer, Polymer oder Dendrimer darstellt.

13. Formulierung, enthaltend mindestens eine Verbindung nach einem oder mehreren der Ansprüche 1 bis 10 oder ein Oligomer, Polymer oder Dendrimer nach Anspruch 12 und mindestens eine weitere Verbindung, insbesondere ein Lösemittel.

14. Verwendung einer Verbindung nach einem oder mehreren der Ansprüche 1 bis 10 oder eines Oligomers, Polymers oder Dendrimers nach Anspruch 12 in einer elektronischen Vorrichtung oder zur Erzeugung von Singulett-Sauerstoff oder in der Photokatalyse oder in Sauerstoffsensoren.

15. Elektronische Vorrichtung enthaltend mindestens eine Verbindung nach einem oder mehreren der Ansprüche 1 bis 10 oder mindestens ein Oligomer, Polymer oder Dendrimer nach Anspruch 12 , insbesondere ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden.

16. Elektronische Vorrichtung nach Anspruch 15, wobei es sich um eine organische Elektrolumineszenzvorrichtung handelt, **dadurch gekennzeichnet, dass** die Verbindung nach einem oder mehreren der Ansprüche 1 bis 10 als emittierende Verbindung in einer oder mehreren emittierenden Schichten eingesetzt wird, bevorzugt in Kombination mit einem Matrixmaterial.

## Claims

1. Compound of the formula (1),
M(L)ₙ(L')ₘ formula (1)
containing a moiety M(L)ₙ of the formula (2): 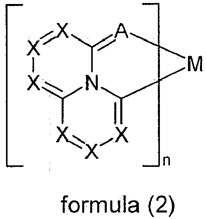 where the following applies to the symbols and indices used:
M is a transition metal;
A is on each occurrence, identically or differently, O, S or NR;
X is on each occurrence, identically or differently, CR or N;
or two adjacent groups stand for a group of the following formula (3) or (4), 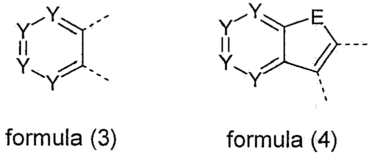 where the dashed bonds indicate the linking of this group in the molecule;
Y is on each occurrence, identically or differently, CR or N;
E is on each occurrence, identically or differently, CR₂, NR, O or S;
R is on each occurrence, identically or differently, H, D, F, Cl, Br, I, N(R¹)₂, P(R¹)₂, CN, NO₂, Si(R₁)₃, B(OR¹)₂, C(=O)R¹, P(=O)(R¹)₂, S(=O)R¹, S(=O)₂R¹, OSO₂R¹, OH, SH, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R¹, where one or more non-adjacent CH₂ groups may be replaced by R¹C=CR¹, C≡C, Si(R¹)₂, Ge(R¹)₂, Sn(R¹)₂, C=O, C=S, C=Se, C=NR¹, P(=O)(R¹), SO, SO₂, NR¹, O, S or CONR¹ and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹, or an aralkyl or heteroaralkyl group having 5 to 60 aromatic ring atoms, which may be substituted by one or more radicals R¹, or an aryloxy or heteroaryloxy group having 5 to 60 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; two or more adjacent radicals R may also form a mono- or polycyclic, aliphatic, aromatic and/or benzo-fused ring system with one another;
R¹ is on each occurrence, identically or differently, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R², where one or more non-adjacent CH₂ groups may be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², or a diarylamino group, diheteroarylamino group or arylheteroarylamino group having 10 to 40 aromatic ring atoms, which may be substituted by one or more radicals R²; two or more adjacent radicals R¹ here may form a mono- or polycyclic, aliphatic or aromatic ring system with one another;
R² is on each occurrence, identically or differently, H, D, F or an aliphatic, aromatic and/or heteroaromatic organic radical having 1 to 20 C atoms, in particular a hydrocarbon radical, in which, in addition, one or more H atoms may be replaced by D or F; two or more substituents R² here may also form a mono- or polycyclic, aliphatic or aromatic ring system with one another;
L' is, identically or differently on each occurrence, any desired co-ligand;
n is 1, 2 or 3;
m is 0, 1, 2, 3 or 4;
a plurality of ligands L here may also be linked to one another or L may be linked to L' via any desired bridge V and thus form a tridentate, tetradentate, pentadentate or hexadentate ligand system.

2. Compound according to Claim 1, **characterised in that** M is selected from the group consisting of iridium, platinum, chromium, molybdenum, tungsten, rhenium, ruthenium, osmium, rhodium, nickel, palladium, copper, silver and gold.

3. Compound according to Claim 1 or 2, **characterised in that** the moiety of the formula (2) is selected from the structures of the formulae (5) to (17), 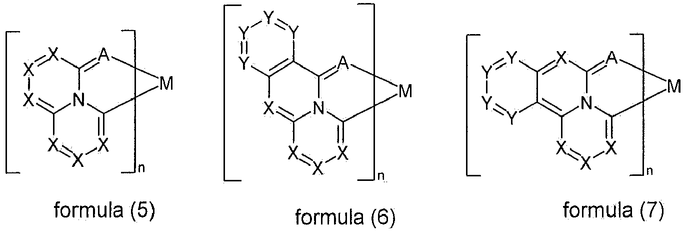 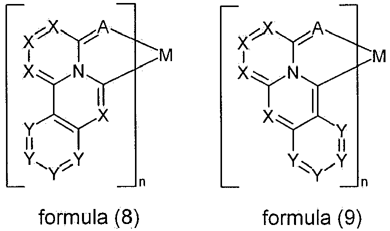 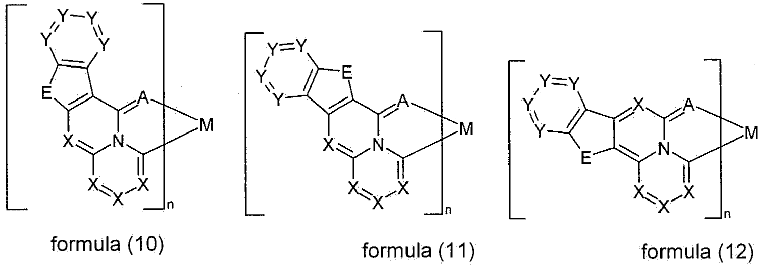 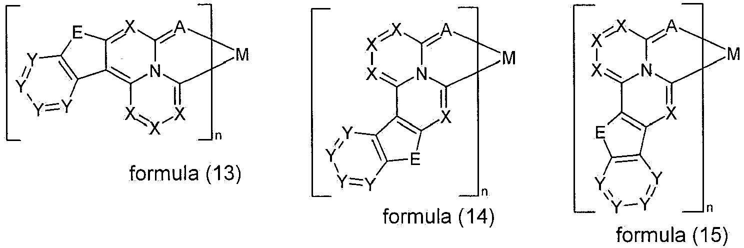 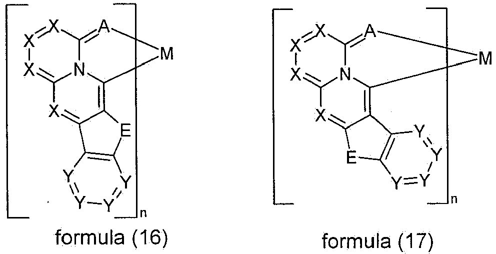 where X stands, identically or differently on each occurrence, for CR or N and the other symbols and indices have the meanings given in Claim 1.

4. Compound according to one or more of Claims 1 to 3, **characterised in that** a maximum of two groups X, preferably a maximum of one group X per ring, stand for nitrogen, and the other groups X in the ring stand for CR and **in that** a maximum of two groups Y, preferably a maximum of one group Y per ring stand for nitrogen, and the other symbols Y in the ring stand for CR.

5. Compound according to one or more of Claims 1 to 4, **characterised in that** the moiety of the formula (2) is selected from the structures of the formulae (5a) to (5d), (7a) to (7c) and (8a) to (8c), 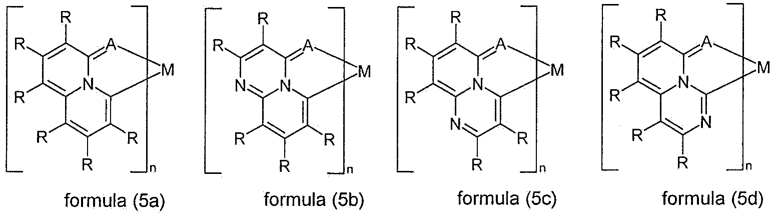 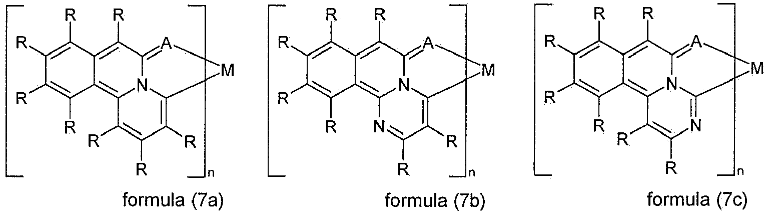 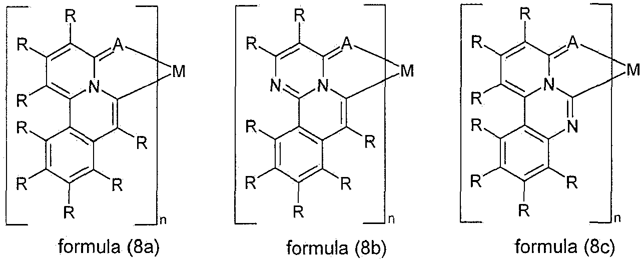 where the symbols and indices used have the meanings given in Claim 1.

6. Compound according to one or more of Claims 1 to 5, **characterised in that** A stands for O or S.

7. Compound according to one or more of Claims 1 to 6, **characterised in that**, if one or more groups X stand for N, at least one substituent R which is not equal to H or D, in particular an alkyl group, alkoxy group, substituted amino group, aralkyl group or an aromatic or heteroaromatic ring system, is bonded adjacent to this N atom.

8. Compound according to one or more of Claims 1 to 7, **characterised in that** the ligand L has two adjacent carbon atoms, which are in each case substituted by radicals R, where the respective radicals R, together with the C atoms, form a ring of the formula (18), (19), (20) or (20a) to (20d), 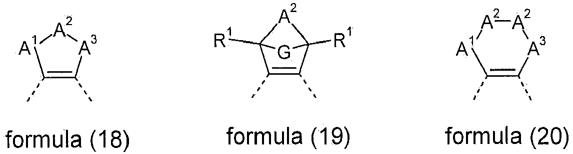 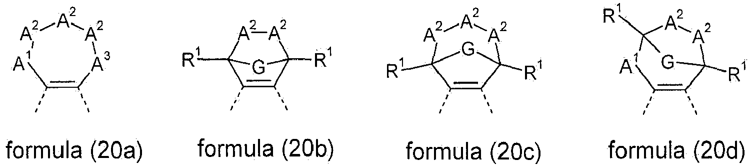 where R¹ and R² have the meanings given above, the dashed bonds indicate the linking of the two carbon atoms in the ligand and furthermore:
A¹, A³ are, identically or differently on each occurrence, C(R³)₂, O, S, NR³ or C(=O);
A² is, identically or differently on each occurrence, C(R¹)₂, O, S, NR³ or C(=O);
or the two groups A² in formula (20) together stand for a group of the following formula (21) or (22), 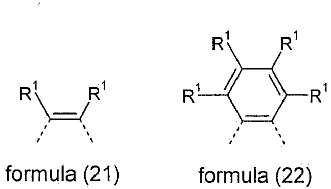
G is an alkylene group having 1, 2 or 3 C atoms, which may be substituted by one or more radicals R², -CR²=CR²- or an ortholinked arylene or heteroarylene group having 5 to 14 aromatic ring atoms, which may be substituted by one or more radicals R²;
R³ is, identically or differently on each occurrence, F, a straight-chain alkyl or alkoxy group having 1 to 20 C atoms, a branched or cyclic alkyl or alkoxy group having 3 to 20 C atoms, which may in each case be substituted by one or more radicals R², where one or more non-adjacent CH₂ groups may be replaced by R²C=CR², C≡C, Si(R²)₂, C=O, NR², O, S or CONR² and where one or more H atoms may be replaced by D or F, or an aromatic or heteroaromatic ring system having 5 to 24 aromatic ring atoms, which may in each case be substituted by one or more radicals R², or an aryloxy or heteroaryloxy group having 5 to 24 aromatic ring atoms, which may be substituted by one or more radicals R², or an aralkyl or heteroaralkyl group having 5 to 24 aromatic ring atoms, which may be substituted by one or more radicals R²; two radicals R³ here may form an aliphatic or aromatic ring system with one another; furthermore, R³ may form an aliphatic ring system with an adjacent radical R or R¹;
with the proviso that no two heteroatoms in A¹-A²-A³ are bonded directly to one another.

9. Compound according to one or more of Claims 1 to 8, selected from the structures of the formulae (24) to (28), 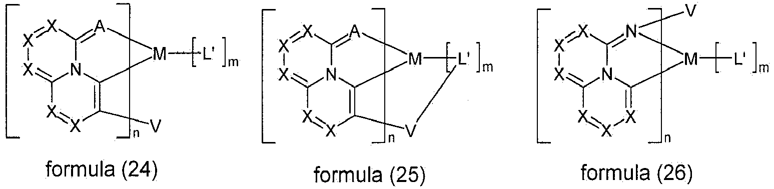 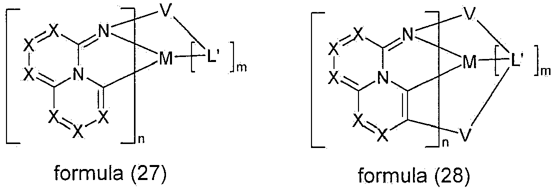 where the symbols and indices used have the meanings given in Claim 1 and V represents a bridging unit containing 1 to 80 atoms from the third, fourth, fifth and/or sixth main group or a 3- to 6-membered homo- or heterocycle, which covalently bonds the part-ligands L to one another or covalently bonds L to L' to one another.

10. Compound according to one or more of Claims 1 to 9, **characterised in that** L' is selected, identically or differently on each occurrence, from the group consisting of carbon monoxide, nitrogen monoxide, alkyl cyanides, aryl cyanides, alkyl isocyanides, aryl isocyanides, amines, phosphines, phosphites, arsines, stibines, nitrogen-containing heterocycles, carbenes, hydride, deuteride, the halides F⁻, Cl⁻, Br and I⁻, alkylacetylides, arylacetylides, cyanide, cyanate, isocyanate, thiocyanate, isothiocyanate, aliphatic or aromatic alcoholates, aliphatic or aromatic thioalcoholates, amides, carboxylates, aryl groups, O²⁻, S²⁻, carbides, nitrenes, diamines, imines, diimines, diphosphines, 1,3-diketonates derived from 1,3-diketones, 3-ketonates derived from 3-ketoesters, carboxylates derived from aminocarboxylic acids, salicyliminates derived from salicylimines, dialcoholates, dithiolates, borates of nitrogen-containing heterocycles and ligands which are formed by a combination of the groups of the formulae (43) to (65), where one group is bonded via a neutral nitrogen atom or a carbene carbon atom and the other group is bonded via a negatively charged carbon atom or a negatively charged nitrogen atom and the ligand is formed through these groups bonding to one another in each case at the position denoted by #, 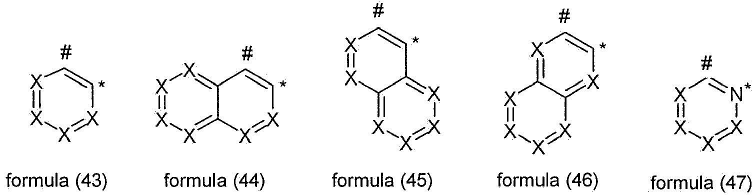 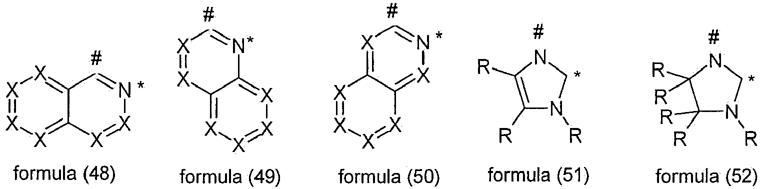 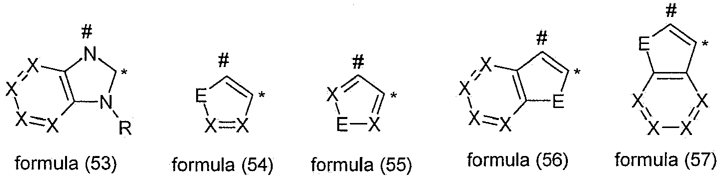 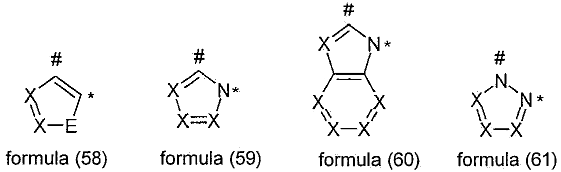 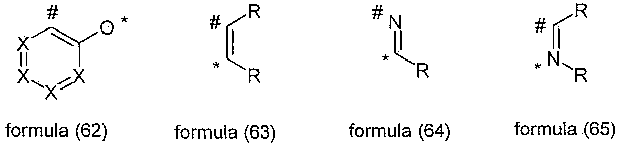 the symboles used here have the meanings given in Claim 1, and the position at which the group coordinates to the metal is denoted by *.

11. Process for the preparation of a compound according to one or more of Claims 1 to 10 by reaction of the corresponding free ligand with metal alkoxides of the formula (70), with metal ketoketonates of the formula (71), with metal halides of the formula (72), with dimeric metal complexes of the formula (73) or with metal compounds which carry both alcoholate and/or halide and/or hydroxyl radicals and also ketoketonate radicals,
M(OR¹)ₙ formula (70) 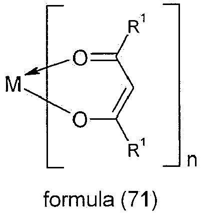
MHalₙ formula (72) 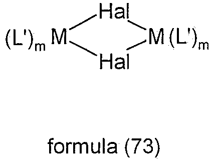
where the symbols and indices M, L', m, n and R¹ have the meanings indicated in Claim 1 and Hal = F, Cl, Br or I.

12. Oligomer, polymer or dendrimer containing one or more of the compounds according to one or more of Claims 1 to 10, where at least one of the radicals R represents a bond to the oligomer, polymer or dendrimer.

13. Formulation comprising at least one compound according to one or more of Claims 1 to 10 or an oligomer, polymer or dendrimer according to Claim 12 and at least one further compound, in particular a solvent.

14. Use of a compound according to one or more of Claims 1 to 10 or an oligomer, polymer or dendrimer according to Claim 12 in an electronic device or for the generation of singlet oxygen or in photocatalysis or in oxygen sensors.

15. Electronic device comprising at least one compound according to one or more of Claims 1 to 10 or at least one oligomer, polymer or dendrimer according to Claim 12 , in particular selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

16. Electronic device according to Claim 15, which is an organic electroluminescent device, **characterised in that** the compound according to one or more of Claims 1 to 10 is employed as emitting compound in one or more emitting layers, preferably in combination with a matrix material.

## Revendications

1. Composé de la formule (1) :
M(L)ₙ(L')ₘ formule (1)
qui contient une moitié M(L)ₙ de la formule (2) : 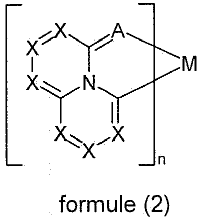 dans lesquelles ce qui suit s'applique aux symboles et aux indices qui sont utilisés :
M est un métal de transition ;
A est pour chaque occurrence, de manière identique ou différente, O, S ou NR ;
X est pour chaque occurrence, de manière identique ou différente, CR ou N ;
ou deux groupes adjacents représentent un groupe de la formule (3) ou (4) : 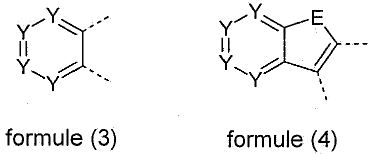 dans lesquelles les liens en pointillées représentent la liaison de ce groupe dans la molécule ;
Y est pour chaque occurrence, de manière identique ou différente, CR ou N ;
E est pour chaque occurrence, de manière identique ou différente, CR₂, NR, O ou S ;
R est pour chaque occurrence, de manière identique ou différente, H, D, F, Cl, Br, I, N(R¹)₂, P(R¹)₂, CN, NO₂, Si(R¹)₃, B(OR¹)₂, C(=O)R¹, P(=O)(R¹)₂, S(=O)R¹, S(=O)₂R¹, OSO₂R¹, OH, SH, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R¹, où un ou plusieurs groupe(s) CH₂ non adjacents peut/peuvent être remplacé(s) par R¹C=CR¹, C≡C, Si(R¹)₂, Ge(R¹)₂, Sn(R¹)₂, C=O, C=S, C=Se, C=NR¹, P(=O)(R¹), SO, SO₂, NR¹, O, S ou CONR¹ et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R¹, ou un groupe aralkyle ou hétéroaralkyle qui comporte de 5 à 60 atomes de cycle aromatique, lequel peut être substitué par un radical ou par plusieurs radicaux R¹, ou un groupe aryloxy ou hétéroaryloxy qui comporte de 5 à 60 atomes de cycle aromatique, lequel peut être substitué par un radical ou par plusieurs radicaux R¹, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R¹ ; deux radicaux R adjacents ou plus peuvent également former un système de cycle aliphatique, aromatique et/ou benzo-fusionné mono- ou polycyclique l'un avec l'autre ou les uns avec les autres ;
R¹ est pour chaque occurrence, de manière identique ou différente, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R², où un ou plusieurs groupe(s) CH₂ non adjacents peut/peuvent être remplacé(s) par R²C=CR², C=C, Si(R²)₂, Gₑ(R²)₂, Sn(R²)₂, C=O, C=S, C=Se, C=NR², P(=O)(R²), SO, SO₂, NR², O, S ou CONR² et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 60 atomes de cycle aromatique, lequel peut être substitué par un radical ou par plusieurs radicaux R², ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R² ; deux radicaux R¹ adjacents ou plus peuvent ici former un système de cycle aliphatique ou aromatique mono- ou polycyclique l'un avec l'autre ou les uns avec les autres ;
R² est pour chaque occurrence, de manière identique ou différente, H, D, F ou un radical organique aliphatique, aromatique et/ou hétéroaromatique qui comporte de 1 à 20 atome(s) de C, en particulier un radical hydrocarbone, où, en outre, un ou plusieurs atome(s) de H peut/peuvent être remplacé(s) par D ou F ; deux substituants R² ou plus peuvent ici également former un système de cycle aliphatique ou aromatique mono- ou polycyclique l'un avec l'autre ou les uns avec les autres ;
L' est, de manière identique ou différente pour chaque occurrence, n'importe quel co-ligand souhaité ;
n est 1, 2 ou 3 ;
m est 0, 1, 2, 3 ou 4 ;
les ligands d'une pluralité de ligands L peuvent ici également être liés les uns aux autres ou L peut être lié à L' via n'importe quel pont souhaité V et peuvent ainsi former un système de ligand(s) tridenté, tétradenté, pentadenté ou hexadenté.

2. Composé selon la revendication 1, **caractérisé en ce que** M est sélectionné parmi le groupe qui est constitué par l'iridium, le platine, le chrome, le molybdène, le tungstène, le rhénium, le ruthénium, l'osmium, le rhodium, le nickel, le palladium, le cuivre, l'argent et l'or.

3. Composé selon la revendication 1 ou 2, **caractérisé en ce que** la moitié de la formule (2) est sélectionnée parmi les structures des formules (5) à (17): 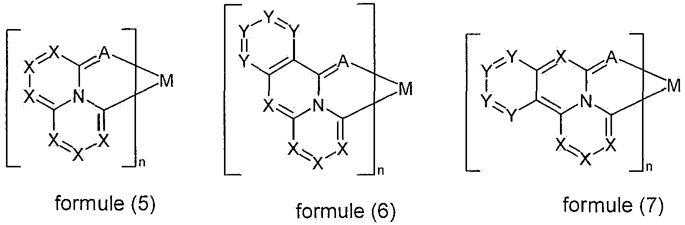 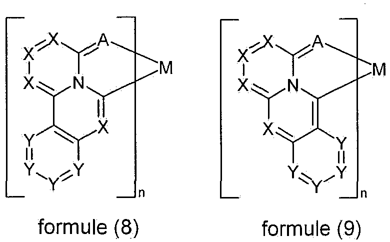 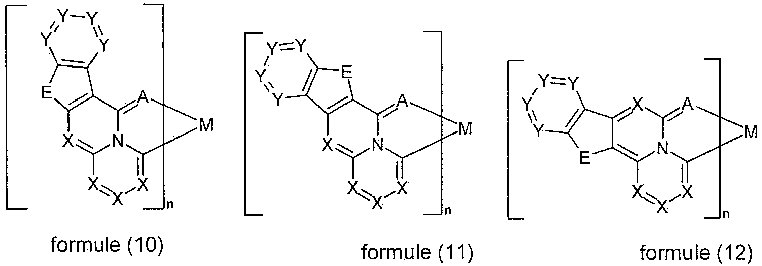 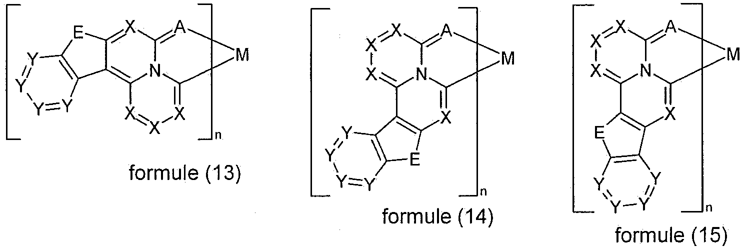 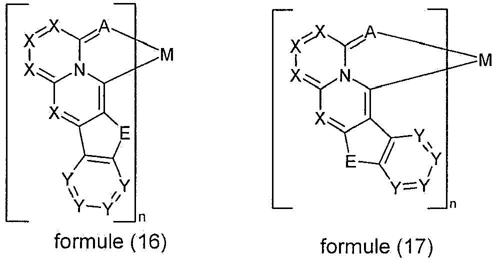 dans lesquelles X représente, de manière identique ou différente pour chaque occurrence, CR ou N et les autres symboles ainsi que les autres indices présentent les significations qui ont été données selon la revendication 1.

4. Composé selon une ou plusieurs des revendications 1 à 3, **caractérisé en ce qu'**un maximum de deux groupes X, de préférence un maximum d'un groupe X par cycle, représente(nt) l'azote et les autres groupes X dans le cycle représentent CR, et **en ce qu'**un maximum de deux groupes Y, de préférence un maximum d'un groupe Y par cycle, représente(nt) l'azote, et les autres symboles Y dans le cycle représentent CR.

5. Composé selon une ou plusieurs des revendications 1 à 4, **caractérisé en ce que** la moitié de la formule (2) est sélectionnée parmi les structures des formules (5a) à (5d), (7a) à (7c) et (8a) à (8c) : 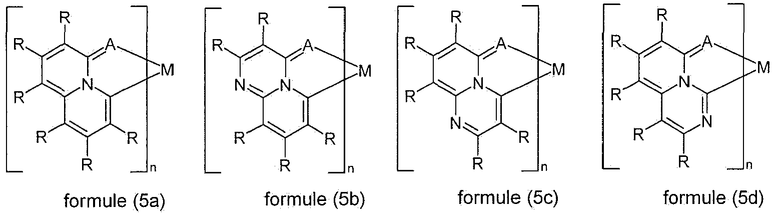 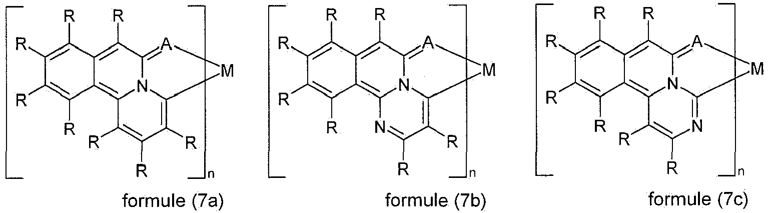 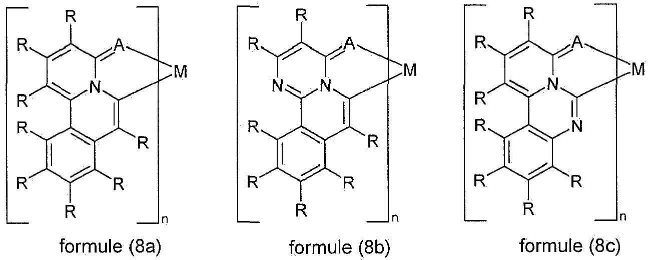 dans lesquelles les symboles et les indices qui sont utilisés présentent les significations qui ont été données selon la revendication 1.

6. Composé selon une ou plusieurs des revendications 1 à 5, **caractérisé en ce que** A représente O ou S.

7. Composé selon une ou plusieurs des revendications 1 à 6, **caractérisé en ce que**, si un ou plusieurs groupe(s) X représente(nt) N, au moins un substituant R qui n'est pas égal à H ou D, en particulier un groupe alkyle, un groupe alcoxy, un groupe amino substitué, un groupe aralkyle ou un système de cycle aromatique ou hétéroaromatique, est lié en une position adjacente à cet atome de N.

8. Composé selon une ou plusieurs des revendications 1 à 7, **caractérisé en ce que** le ligand L comporte deux atomes de carbone adjacents, lesquels sont dans chaque cas substitués par des radicaux R, où les radicaux R respectifs, en association avec les atomes de C, forment un cycle de la formule/des formules (18), (19), (20) ou (20a) à (20d) : 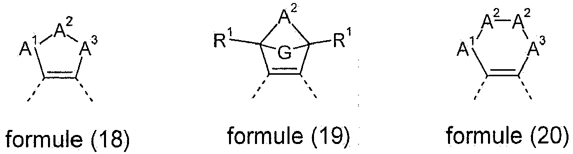 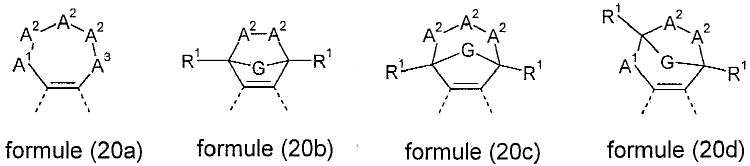 dans lesquelles R¹ et R² présentent les significations qui ont été données ci-avant, les liens en pointillés indiquent la liaison des deux atomes de carbone dans le ligand et en outre :
A¹, A³ sont, de manière identique ou différente pour chaque occurrence, C(R³)₂, O, S, NR³ ou C(=O) ;
A² est, de manière identique ou différente pour chaque occurrence, C(R¹)₂, O, S, NR³ ou C(=O) ;
ou les deux groupes A² dans la formule (20) représentent en association un groupe de la formule (21) ou (22) qui suit : 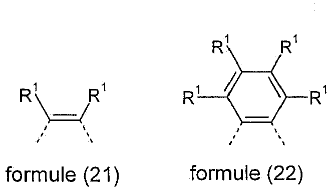
G est un groupe alkylène qui comporte 1, 2 ou 3 atome(s) de C, lequel peut être substitué par un radical ou par plusieurs radicaux R², -CR²=CR²- ou un groupe arylène ou hétéroarylène ortho-lié qui comporte de 5 à 14 atomes de cycle aromatique, lequel peut être substitué par un radical ou par plusieurs radicaux R² ;
R³ est, de manière identique ou différente pour chaque occurrence, F, un groupe alkyle ou alcoxy en chaîne droite qui comporte de 1 à 20 atome(s) de C, un groupe alkyle ou alcoxy ramifié ou cyclique qui comporte de 3 à 20 atomes de C, lequel peut dans chaque cas être substitué par un radical ou par plusieurs radicaux R², où un ou plusieurs groupe(s) CH₂ non adjacents peut/peuvent être remplacé(s) par R²C=CR², C≡C, Si(R²)₂, C=O, NR², O, S ou CONR² et où un ou plusieurs atome(s) de H peut/peuvent être remplacé(s) par D ou F, ou un système de cycle aromatique ou hétéroaromatique qui comporte de 5 à 24 atomes de cycle aromatique, lequel peut dans chaque cas être substitué par un radical ou par plusieurs radicaux R², ou un groupe aryloxy ou hétéroaryloxy qui comporte de 5 à 24 atomes de cycle aromatique, lequel peut être substitué par un radical ou par plusieurs radicaux R², ou un groupe aralkyle ou hétéroaralkyle qui comporte de 5 à 24 atomes de cycle aromatique, lequel peut être substitué par un radical ou par plusieurs radicaux R² ; deux radicaux R³ peuvent ici former un système de cycle aliphatique ou aromatique l'un avec l'autre ; en outre, R³ peut former un système de cycle aliphatique avec un radical R ou R¹ adjacent ;
étant entendu que deux hétéroatomes dans A¹-A²-A³ ne sont pas liés directement l'un à l'autre.

9. Composé selon une ou plusieurs des revendications 1 à 8, lequel est sélectionné parmi les structures des formules (24) à (28) : 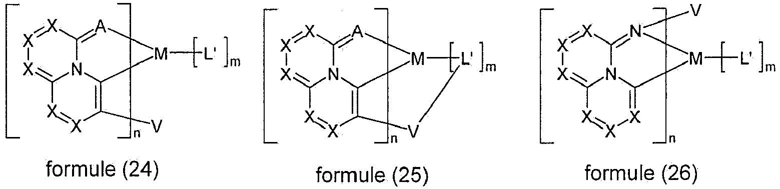 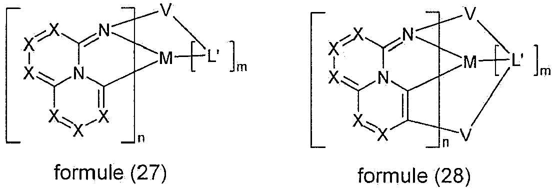 dans lesquelles les symboles et les indices qui sont utilisés présentent les significations qui ont été données selon la revendication 1 et V représente une unité de pontage qui contient de 1 à 80 atome(s) dont l'origine est les troisième, quatrième, cinquième et/ou sixième groupe(s) principal/principaux ou un homocycle ou hétérocycle à 3 à 6 éléments, qui lie de façon covalente les ligands partiels L les uns aux autres ou qui lie de façon covalente L à L' l'un à l'autre.

10. Composé selon une ou plusieurs des revendications 1 à 9, **caractérisé en ce que** L' est sélectionné, de manière identique ou différente pour chaque occurrence, parmi le groupe qui est constitué par le monoxyde de carbone, le monoxyde d'azote, les cyanures d'alkyle, les cyanures d'aryle, les isocyanures d'alkyle, les isocyanures d'aryle, les amines, les phosphines, les phosphites, les arsines, les stibines, les hétérocycles contenant de l'azote, les carbènes, un hydrure, un deutéride, les halogénures F⁻, Cl⁻, Br et I⁻, les alkylacétylures, les arylacétylures, un cyanure, un cyanate, un isocyanate, un thiocyanate, un isothiocyanate, les alcoolates aliphatiques ou aromatiques, les thioalcoolates aliphatiques ou aromatiques, les amides, les carboxylates, les groupes aryle, O²⁻, S²-, les carbures, les nitrènes, les diamines, les imines, les diimines, les diphosphines, les 1,3-dicétonates qui sont dérivés à partir des 1,3-dicétones, les 3-cétonates qui sont dérivés à partir des 3-cétoesters, les carboxylates qui sont dérivés à partir des acides aminocarboxyliques, les salicyliminates qui sont dérivés à partir des salicylimines, les dialcoolates, les dithiolates, les borates d'hétérocycles contenant de l'azote et des ligands, lesquels sont formés au moyen d'une combinaison des groupes des formules (43) à (65), où un groupe est lié via un atome d'azote neutre ou un atome de carbone carbène et l'autre groupe est lié via un atome de carbone chargé négativement ou un atome d'azote chargé négativement et le ligand est formé par l'intermédiaire de la liaison de ces groupes les uns aux autres, dans chaque cas au niveau de la position qui est indiquée au moyen de # ; 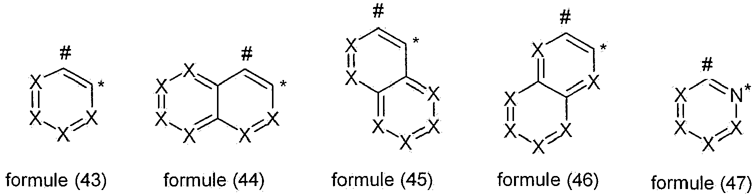 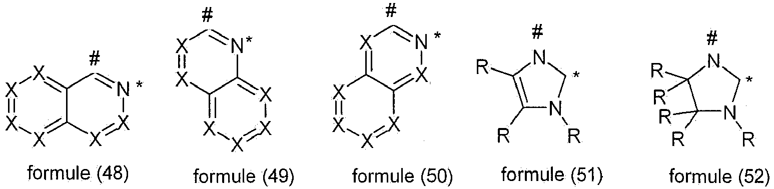 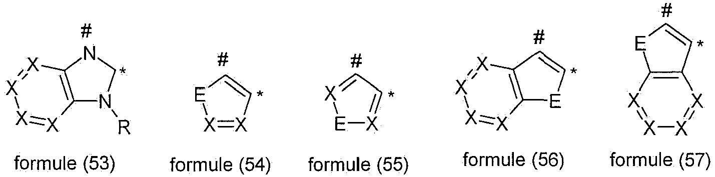 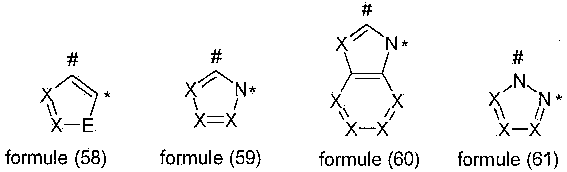 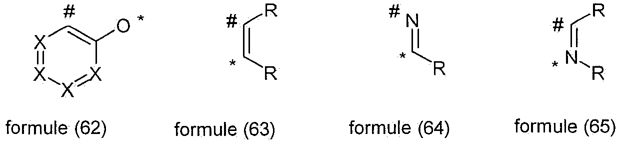 les symboles qui sont utilisés ici présentent les significations qui ont été données selon la revendication 1, et la position au niveau de laquelle le groupe est coordonné sur le métal est indiquée au moyen de *.

11. Procédé pour la préparation d'un composé selon une ou plusieurs des revendications 1 à 10 au moyen de la réaction du ligand libre correspondant avec des alcoxydes de métal/métaux de la formule (70), avec des cétocétonates de métal/métaux de la formule (71), avec des halogénures de métal/métaux de la formule (72), avec des complexes de métal/métaux dimériques de la formule (73) ou avec des composés de métal/métaux qui sont porteurs à la fois de radicaux alcoolate et/ou halogénure et/ou hydroxyle et également de radicaux cétocétonate :
M(OR¹)ₙ formule (70) 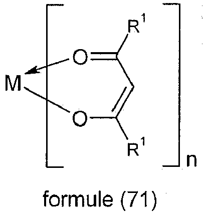
MHalₙ formule (72) 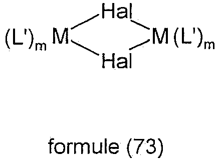
dans lesquelles les symboles et les indices M, L', m, n et R¹ présentent les significations qui ont été indiquées selon la revendication 1 et Hal = F, Cl, Br ou I.

12. Oligomère, polymère ou dendrimère contenant un ou plusieurs des composés selon une ou plusieurs des revendications 1 à 10, où au moins l'un des radicaux R représente une liaison sur l'oligomère, le polymère ou le dendrimère.

13. Formulation comprenant au moins un composé selon une ou plusieurs des revendications 1 à 10 ou un oligomère, un polymère ou un dendrimère selon la revendication 12 et au moins un autre composé, en particulier un solvant.

14. Utilisation d'un composé selon une ou plusieurs des revendications 1 à 10 ou d'un oligomère, d'un polymère ou d'un dendrimère selon la revendication 12 dans un dispositif électronique ou pour la génération d'un oxygène singulet ou lors d'une photocatalyse ou dans des capteurs d'oxygène.

15. Dispositif électronique comprenant au moins un composé selon une ou plusieurs des revendications 1 à 10 ou au moins un oligomère, un polymère ou un dendrimère selon la revendication 12, en particulier sélectionné parmi le groupe qui est constitué par les dispositifs électroluminescents organiques, les circuits intégrés organiques, les transistors à effet de champ organiques, les transistors à film mince organiques, les transistors à émission de lumière organiques, les cellules solaires organiques, les détecteurs optiques organiques, les photorécepteurs organiques, les dispositifs à extinction de champ organiques, les cellules électrochimiques à émission de lumière ou les diodes laser organiques.

16. Dispositif électronique selon la revendication 15, lequel est un dispositif électroluminescent organique, **caractérisé en ce que** le composé selon une ou plusieurs des revendications 1 à 10 est utilisé en tant que composé d'émission dans une ou plusieurs couche(s) d'émission, de préférence en combinaison avec un matériau de matrice.
